# EUROPÄISCHE PATENTSCHRIFT

(11) **EP 2 429 176 B1**
(45) Veröffentlichungstag und Bekanntmachung des Hinweises auf die Patenterteilung: **16.04.2014**
(21) Anmeldenummer: 11192388.4
(22) Anmeldetag: 12.10.2010
(51) Int. Cl.: H04N 5/225, H04N 5/217, H04N 5/357, G02B 3/00

(54) **Bildverarbeitungsvorrichtung**
Image processing device
Dispositif de traitement d'image

(30) Priorität: 14.10.2009 DE 102009049387
(43) Veröffentlichungstag der Anmeldung: 14.03.2012
(62) Teilanmeldung aus: 10771393.5
(73) Patentinhaber: Fraunhofer-Gesellschaft zur Förderung der angewandten Forschung e.V., 80686 München (DE)
(72) Erfinder: Brueckner, Andreas, 07743 Jena (DE); Duparré, Jacques, 07745 Jena (DE); Wippermann, Frank, 98617 Meiningen (DE); Bräuer, Andreas, 07646 Schloeben (DE); Dannberg, Peter, 07745 Jena (DE)
(74) Vertreter: Schenk, Markus

(56) Entgegenhaltungen:
- EP-A2- 0 840 502
- EP-B1- 1 665 779
- WO-A1-2008/025610
- WO-A1-2010/078563
- WO-A2-2006/039486
- US-A- 4 585 948
- US-A- 5 796 522
- US-A1- 2007 081 815
- US-A1- 2009 135 289

## Beschreibung

### Hintergrund der Erfindung

Die vorliegende Erfindung bezieht sich auf eine Vorrichtung, eine Bildverarbeitungsvorrichtung und ein Verfahren zur optischen Abbildung, welche beispielsweise in miniaturisierten Kamerasystemen für tragbare Endgeräte zum Einsatz kommen können.

Der Einsatz miniaturisierter Kamerasysteme für tragbare Endgeräte (Mobiltelefon, PDA, Laptop etc.) bedingt neben der Verkleinerung elektronischer und optoelektronischer Bauteile auch die Miniaturisierung der Abbildungsobjektive. Die Voraussetzungen dafür sind kurze Objektivbaulängen und eine geringe Anzahl von optischen Komponenten (vor allem Linsenelemente). Die fortschreitende Verringerung der Bildsensordiagonale, welche durch die Entwicklung der Halbleiterstrukturierungstechnologie (kleinere Photodioden, gleich größere Anzahl von Pixeln auf gleicher Bildfläche) sowie durch die Reduktion der Sensorherstellungskosten getrieben ist, verlangt jedoch, dass trotz der Vereinfachung des Optikaufbaus, ein hohes Auflösungsvermögen und eine hohe Lichtstärke der Optik erreicht werden müssen. Die vorhandenen Optikdesignlösungen zeichnen sich durch wenige, dafür aber komplexe (zumeist asphärische) Linsenformen aus, welche die Möglichkeiten der aktuellen Herstellungstechnologien erschöpfen. Durch unzureichende Messverfahren für die Qualitätskontrolle solcher komplexen Flächen und die hochpräzisen lateralen und axialen Montagegenauigkeiten, die notwendig sind, um die optischen Bauteile eines solchen miniaturisierten Kameraobjektives zu fassen, sind in der Realisierung weitere Grenzen gesetzt. Bestehende Lösungen für miniaturisierte Kameramodule genügen entweder nicht den Spezifikationen oder den Preisvorstellungen der Integratoren und Anwender.

Ein etabliertes Herstellungsverfahren kleiner Kameraoptiken ist die Erzeugung von Einzellinsen und Fassungen durch Kunststoffspritzguß in ultrapräzisionsbearbeiteten Formeinsätzen. Für gewöhnlich können dabei die Linsen zusammen mit deren Fassung in Zweikomponentenspritzguß hergestellt werden. Die Einzelkomponenten werden im Anschluss in einer Steckfassung montiert und mittels formschlüssiger Verbindung (Ansprengen, Kleben) fixiert. Dieses Verfahren ist jedoch für die Herstellung von miniaturisierten Objektiven mit einer Baugröße kleiner als 5 x 5 x 5 mm³ nicht mehr mit hinreichender Justagegenauigkeit anwendbar. Weitere Probleme ergeben sich für die Zuführung sowie die Aufbau- und Verbindungstechnik derartig kleiner Komponenten. Im Detail entstehen Probleme der Handhabung der Bauteile aufgrund von elektrostatischen Kräften (kleines Gewicht und Abmessungen der Bauteile) sowie der Gefahr der Verschmutzung und des Zerkratzens der empfindlichen optischen Flächen. Aus diesen Gründen entfallen über 80 % der Produktionskosten auf die Montageprozesse. Es existieren zwar fortschrittliche Ansätze für die Handhabung kleiner Optiken in hybrider Aufbautechnik (sensorisch gestützte mechanische und elektrostatische sowie pneumatische Mikrogreifer), diese erhöhen jedoch erheblich die Kosten für eine Massenfertigung (z. B, Kameraoptiken für Mobiltelefone). Des Weiteren wird durch die hybride Fertigungstechnik für höhere Auflösungsfonnate eine aktive Positionierung z. B. Pieozostelltrieb der Kunststoffoptiken benötigt, um die Toleranzen der Montage des Objektivs auf dem optoelektronischen Bildwandler (Bildsensor) auszugleichen. Dies führt zu einer weiteren Erhöhung des Stückpreises.

Ein alternatives Verfahren für Objekte der Größenordnung kleiner als 5 x 5 x 5 mm³ stellt die Herstellung von Optiken im Wafermaßstab (WLO-wafer level optics) dar. Hier verwendet man einen Werkzeugeinsatz für die jeweiligen Einzellinsen, der durch Ultrapräzisionsbearbeitung (z. B. Diamantdrehen) erzeugt wurde, zur mehrfachen UV-Abformung (Step- und Repeatprozess) der Einzelkomponente auf einem Substratwafer (Waferlevel Optikmodule). Alternativ kann ein ganzer Werkzeugwafer immer gleicher Einzelkomponenten mittels Ultrapräzisionsbearbeitung erstellt und anschließend in einem einzigen UV-Abformschritt im Wafermaßstab repliziert werden. Viele gleichartige Linsen, aber auch Abstandshalter und Blenden können auf diese Weise parallel hergestellt werden. In nachfolgenden Schritten können die einzelnen Waferplatten axial miteinander gebondet werden, um einen Waferstapel mit einer Vielzahl von Objektiven zu erhalten. Hierbei handelt es sich um eine parallelisierte Herstellungstechnologie, die auf Prozesse und Anlagen der Mikroelektronikfertigung zurückgreift. Die Hauptnachteile der Anwendung dieser Herstellungsverfahren der Mikrooptik für miniaturisierte Linsen, die aber im Vergleich zu üblichen Mikrolinse groß ausfallen, sind die hohen Kosten für die Herstellung geeigneter Abformwerkzeuge sowie die durch z. B.Materialschrumpf limitierte Genauigkeit der erreichbaren Oberflächenprofile bei der UV-Replikation von Mikrolinse großer Scheitelhöhen (größer 100 µm). Des Weiteren verbleiben Probleme bei der Reproduzierbarkeit und Qualitätsprüfung, insbesondere der Charakterisierung der komplexen Linsenform dieser Größenordnung, bisher ungelöst. Die Module können bisher nur im Verbund mit allen anderen optischen Komponenten mit einem bildgebenden Verfahren getestet werden, was abhängig von der Anzahl der Komponenten und Herstellungsschritte die Ausbeute stark reduziert.

Weiterhin existieren Anordnungen eines flachen optischen Abbildungssensors, der die technische Umsetzung des Appositionsfacettenauges der Insekten darstellt. In diesem extrem kompakten, mehrkanaligen Abbildungssystem ist jeder Mikrolinse ein Photodetektor (Pixel) zugeordnet.

Im Folgenden wird ein Photodetektor teilweise auch als Bilddetektor oder auch als Photodiode bezeichnet.

Durch den Versatz des Photodetektors zur jeweiligen Mikrolinse kann, trotz der geringen Baugröße, ein sehr großes Gesichtsfeld aufgespannt werden. Aufgrund der Verwendung eines Photodetektors pro Kanal besteht jedoch der Bedarf für eine große Grundfläche des Photodetektorenfeldes (CMOS oder CCD-Bildsensor) um ein moderates Bildauflösungsvermögen zu erreichen. Dies erhöht die Herstellungskosten eines entsprechenden miniaturisierten abbildenden Sensors beträchtlich.

Die Druckschriften DE 10 2004 003 013.8 und PCT PAT. APPL. WO 2005/069607 beschreiben ein mehrkanaliges Abbildungssystem auf Basis eines künstlichen Facettenauges, wobei hier jedem Kanal ein Bilddetektor zugeordnet ist, oder einige wenige Bilddetektoren unterschiedlicher Funktionen zugeordnet sind. Jeder Kanal erfasst damit nur einen eng begrenzten Bereich des Objektfeldes.

Die Druckschriften US 005696371 A und EP 0840502A2 beschreiben ein weiteres mehrkanaliges Abbildungssystem auf Basis künstlicher Facettenaugen. Es wird eine kompakte digitale Kamera mit einer mehrkanaligen refraktiven/diffraktiven Abbildungsoptik und segmentierten Gesichtsfeld beschrieben. Das System besteht aus einer Feldanordnung von Linsen, die als dezentrierte Linsensegmente ausgeformt sind, in deren Brennweite sich ein photoempfindliches Bildsensorfeld befindet. Axial vor dem Linsenfeld werden zwei Blendenfelder mit schräg verlaufenden Seitenwänden und einer gegenüber dem Linsenfeld größeren Periode verwendet, um die Gesichtfeldgröße vorzugeben. Zur Unterdrückung von optischem Übersprechen werden senkrechte Wände aus lichtabsorbierendem Material zwischen benachbarten optischen Kanälen vorgeschlagen.

Die Druckschrift J. Tanida, T. Kumagai, K. Yamada und S. Miyatake, "Thin observation module by bound optics (Tombo) concept and experimental verification" Appl. Opt. 40, Seiten 1806-1813, April 2001 zeigt eine weitere mehrkanalige Anordnung zur optischen Abbildung. Aus dieser Schrift ist eine mehrkanalige Anordnung bekannt, bei der sich die Mikrobilder des optoelektronischen Bildsensors zentriert axial unter der jeweils zugeordneten Mikrolinse befinden und benachbarte Kanäle mit senkrechten, lichtundurchlässigen Wänden voneinander getrennt sind. Mit dieser Anordnung kann jedoch nur ein kleines Objektfeld erfasst werden. Für kleine Objektentfernungen (etwa kleiner 2 m) kann durch den auftretenden Blickwinkelversatz (Parallaxe) benachbarter Kanäle auf denselben Objektpunkt eine Subpixelverschiebung der Mikrobildabbildung in Bezug auf die kanalweise Photodiodengruppe des Bildsensors erhalten werden, welche mittels eines Super Resolution Algorithmus aus der Vielzahl der niedrig aufgelösten Mikrobilder ein hoch aufgelöstes Gesamtbild errechnet. Diese Anordnung kann prinzipbedingt nur für kleine Objektabstände und kleine Objektfeldgrößen verwendet werden. Weiterhin besitzt dieses Verfahrens eine erhöhte Bildauslese und Verarbeitungszeit, da der Super Resolution Algorithmus (bekannt aus der Bildverarbeitung) eine hohe Komplexität besitzt.

Eine alternative technische Umgehungsmöglichkeit stellt die Nutzung sehr kleiner Photodioden (Pixel) für den optoelektronischen Bildsensor in Verbindung mit einer einkanaligen Optik dar. Die somit kleine Bilddiagonale führt bei einer kurzen Baulänge der Optik zu kleinen Objektfeldwinkeln am Rand (geringe off-axis Aberrationen und geringe Vignettierung) und somit aber auch zu dem Nachteil der Erfassung nur eines kleinen Objektfeldes. Für diese miniaturisierte Einkanaloptik kann eine relativ kleine Linse mit sehr geringer Baulänge und hinreichender Bildqualität verwendet werden, so dass auch hier die erfindungsgemäßen (lithographischen) Technologien im Wafermaßstab abgewendet werden können. Allerdings haben kleine Pixel den Nachteil, geringer photoempfindlicher Fläche und damit, bei gleicher Blendenzahl der Optik, geringer Empfindlichkeit der Gesamtanordnung.

Die US 2009/0135289 A1 zeigt ein optisches System mit Mikrolinse und photoelektrischen Wandlungseinheiten. Dabei besteht jeweils eine Zuordnung zwischen einer photoelektrischen Wandlungseinheit und einer Mikrolinse, so dass eine solche photoelektrische Wandlungseinheit in Verbindung mit einer Mikrolinse einen sogenannten ,,focus detection pixel" bildet.

Die US 5 796 522 zeigt eine optische Anordnung mit einem Linsenfeld und einem Aperturfeld. Einfallende Strahlen treffen durch das Linsenfeld und die Öffnungen des Aperturfelds auf Bildsegmente.

Die WO 2008/025610 A1 zeigt ein Bilderfassungssystem mit Mikrolinsen, wobei jede Mikrolinse einer Öffnung einer Lochmaske sowie einem Bildsensor eines Bildsensorelements zugeordnet ist.

Die US 4 585 948 zeigt ein optisches System mit Linsen, welche auf einer Detektorschicht angeordnet sind.

Die EP 1 665 779 B1 zeigt ein Bilderfassungssystem mit Mikrolinse auf einem Glassubstrat und einem Pinhole-Array. Das Pinhole-Array dient zum Abdecken eines Detektor-Arrays.

Die US 2007/0081815 A1 zeigt ein Gerät zum simultanen Aufnehmen mehrerer Bilder mit überlappenden Sichtbereichen unter der Nutzung verschiedener Regionen eines Bilddetektors. Eine Mehrzahl von Bildern, die mit verschiedenen Regionen des Bilddetektors aufgenommen werden, können so einem sogenannten "All in Focus"-Bild zusammengefügt werden. Das entstandene "All in Focus"-Bild hat weniger Pixel als die Anzahl der Pixel des Detektors, aber alle Pixel liegen im Fokus.

Zusammenfassend kann festgehalten werden, dass sich im Stand der Technik keine vorteilhafte Bauform einer Abbildungsvorrichtung findet, die eine hohe Bildqualität mit einer kleinen Bauhöhe vereint und dabei kosteneffizient durch bekannte mikrooptische Herstellungstechnologien hergestellt werden kann.

Es ist somit die Aufgabe der vorliegenden Erfindung, eine Vorrichtung und ein Verfahren zur optischen Abbildung zu schaffen, die bei geringer Bauhöhe die Erzielung einer hohen Bildqualität ermöglicht und dabei kosteneffizient durch mikrooptische Herstellungstechnologien realisiert werden kann.

### Zusammenfassung der Erfindung

Diese Aufgabe wird durch eine Bildverarbeitungsvorrichtung gemäß Anspruch 1 gelöst.

Die vorliegende Erfindung schafft eine Vorrichtung zur optischen Abbildung (beispielsweise auch als optische Abbildungsvorrichtung oder als mehrkanaliges Abbildungs- und Bildaufnahmesystem bezeichnet) mit einem Mikrolinsenfeld mit mindestens zwei Mikrolinsen, und einem Bildsensor mit mindestens zwei Bilddetektorenmatrizen, wobei die zumindest zwei Bilddetektorenmatrizen (beispielsweise auch als Photodiodengruppen oder Photodiodenmatrizen oder Photodiodenfelder bezeichnet) jeweils eine Mehrzahl von Bilddetektoren umfassen.

Zwischen den Bilddetektorenmatrizen und den Mikrolinse besteht eine Zuordnung, so dass jede Mikrolinse zusammen mit einer Bilddetektorenmatrize einen optischen Kanal bildet. Die Mittelpunkte der Bilddetektorenmatrizen sind lateral unterschiedlich weit gegenüber auf die Bilddetektorenmatrizen projizierten Flächenschwerpunkten der Mikrolinsenaperturen der zugehörigen optischen Kanäle verschoben. Die verschiedenen optischen Kanäle haben damit verschiedene, aber teilweise überlappende Erfassungsbereiche. Ein Überlappbereich zweier Erfassungsbereiche zweier optischer Kanäle wird damit, im Hinblick auf ein Bilddetektorraster der Bilddetektorenmatrizen versetzt auf die Bilddetektorenmatrizen der optischen Kanäle abgebildet.

Es ist der Kerngedanke der vorliegenden Erfindung, dass es möglich ist, eine Vorrichtung zur optischen Abbildung zu schaffen, indem ein Objektfeld in mehrere Teilbereiche aufgeteilt wird und jeder Teilbereich durch mindestens eine Mikrolinse eines Mikrolinsenfeldes auf eine zugeordnete Bilddetektorenmatrize abgebildet wird. Aufgrund der Überlappung der Erfassungsbereiche der verschiedenen optischen Kanäle werden Teilbereiche des Objektfelds parallel von mehreren Bilddetektorenmatrizen der optischen Kanäle erfasst.

Der Vorteil der vorliegenden Erfindung besteht somit darin, dass die parallele Erfassung von Teilbereichen des Objektfeldes in getrennten optischen Kanälen eine kurze Brennweite jedes einzelnen Kanals erlaubt und damit eine Verringerung der Baulänge der Abbildungsvorrichtung für ein ausgedehntes Objektfeld ermöglicht. Weiterhin ermöglicht die kurze Brennweite in Verbindung mit einem gegenüber dem Gesamtobjektfeld kleinen Objektfeld für einen jeweiligen Einzelkanal die Verwendung einfacher optischer Komponenten (beispielsweise refraktive Linse mit geringer Scheitelhöhe) pro Kanal. Weiterhin ist vorteilhaft, dass das maximale Gesichtsfeld durch die lateralen Abmaße (beispielsweise Anzahl der Kanäle) bestimmt ist und somit im Wesentlichen unabhängig von der Baulänge oder der Komplexität des optischen Aufbaus jedes einzelnen Kanals ist. Aufgrund der Überlappung der Erfassungsbereiche der optischen Kanäle wird zudem ein hohes Bildauflösungsvermögen, im Vergleich zu den künstlichen Facettenaugen im Stand der Technik, erreicht. Weiterhin kann eine optische Vorrichtung gemäß der vorliegenden Erfindung aufgrund ihrer geringen Komplexität und Größe mit etablierter mikrooptischer Herstellungstechnologie (Laserschreiben, Photolithographie, Schmelzen bzw. Rückflussschmelzen ("Reflow"), UV-Abformung im Wafermaßstab) erzeugt werden. Diese Technologien sind ausgereift hoch präzise und kostengünstig in der Massenfertigung einsetzbar.

Ein weiterer Aspekt basiert auf der Erkenntnis, dass eine höhere Bildqualität erreicht werden kann, wenn eine Bildverarbeitungsvorrichtung eine Bildverarbeitungseinrichtung zur Korrektur von Bildfehlem und zur Rekonstruktion eines Gesamtbildes umfasst, welche ausgelegt ist um die Korrektur der Bildfehler der Einzelabbildungen aller Bilddetektorenmatrizen, unabhängig voneinander zeitlich parallel auszuführen und um aus den Einzelabbildungen ein Gesamtbild zu rekonstruieren derart, dass die Verschränkung der Einzelabbildungen berücksichtigt ist.

Ein weiterer Vorteil der vorliegenden Erfindung ist damit, dass durch eine Bildverarbeitungsvorrichtung mit einer Bildverarbeitungseinrichtung zur Korrektur von Bildfehlem eine höhere Bildqualität erzielt werden kann.

Bevorzugte Ausführungsbeispiele der vorliegenden Erfindung werden nachfolgend bezugnehmend auf die beiliegenden Zeichnungen näher erläutert.

Es zeigen:
- Fig. 1: eine schematische Darstellung einer erfindungsgemäßen optischen Abbildungsvorrichtung gemäß einem ersten Ausführungsbeispiel der vorliegenden Erfindung;
- Fig. 2: eine Zeichnung zur Abtastung eines Objektfeldes durch das erste Ausführungsbeispiel mit zusätzlichen kanalweisen Abtastgittern;
- Fig. 3: eine vereinfachte schematische Draufsicht auf eine optische Abbildungsvorrichtung gemäß dem zweiten Ausführungsbeispiel der vorliegenden Erfindung;
- Fig. 4: eine schematische Darstellung der Abtastung des Objektfeldes durch eine optische Abbildungsvorrichtung gemäß dem zweiten Ausführungsbeispiel der vorliegenden Erfindung sowie eine Darstellung der stufenweisen Bildvorverarbeitung;
- Fig. 5A: eine schematische Draufsicht auf einen Teilbereich einer optischen Abbildungsvorrichtung gemäß dem zweiten Ausführungsbeispiel der vorliegenden Erfindung mit den durch Ziffern gekennzeichneten Einzelkanälen;
- Fig. 5B: eine vereinfachte Darstellung des von dem Teilbereich aus Fig. 5A beobachteten Objektfeldbereiches;
- Fig. 6A: eine schematische Draufsicht auf einen Teilbereich einer optischen Abbildungsvorrichtung gemäß dem zweiten Ausführungsbeispiel der vorliegenden Erfindung, mit zusätzlich kanalweise integrierten spektralen Transmissionsfeldern (Flächenmuster);
- Fig. 6B: vereinfachte Darstellung eines von dem Teilbereich aus Fig. 6A beobachteten Objektfeldbereichs;
- Fig. 7A: eine qualitative Darstellung der Verzeichnung in einem zentralen Objektfeldbereich einer optischen Abbildungsvorrichtung gemäß dem zweiten Ausführungsbeispiel der vorliegenden Erfindung;
- Fig. 7B: eine qualitative Darstellung der Verzeichnung eines äußeren Objektfeldbereich einer optischen Abbildungsvorrichtung gemäß dem zweiten Ausführungsbeispiel der vorliegenden Erfindung unter schrägem Einfallswinkel;
- Fig. 8: eine Darstellung des prinzipiellen Verlaufs der positiven tonnenförmigen Verzeichnung;
- Fig. 9: eine schematische Darstellung der Verzerrung des Bildes eines quadratischen Objektbereichs bei einer optischen Abbildungsvorrichtung gemäß dem zweiten Ausführungsbeispiel der vorliegenden Erfindung mit einem Gitterobjekt, wobei rechts ein Schema unter Verwendung einer Verarbeitungseinrichtung zur Verzeichniskorrektur und als Vergleichsbeispiel links ein Schema ohne Verwendung dieser gezeigt ist;
- Fig. 10: Darstellung des Einfallswinkels (in Grad) des Hauptstrahls des zweiten Ausführungsbeispiels der vorliegenden Erfindung sowie des Hauptstrahls einer optischen Abbildungsvorrichtung gemäß einem dritten Ausführungsbeispiel der vorliegenden Erfindung auf die Ebene des Bildsensors;
- Fig. 11: eine schematische Darstellung der wichtigsten Abtastprinzipien des Objektfeldes;
- Fig. 12: eine schematische Schnittansicht einer optischen Abbildungsvorrichtung gemäß dem zweiten Ausführungsbeispiel der vorliegenden Erfindung;
- Fig. 13: eine schematische Schnittansicht einer optischen Abbildungsvorrichtung gemäß dem dritten Ausführungsbeispiel der vorliegenden Erfindung;
- Fig. 14: eine schematische Schnittansicht einer optischen Abbildungsvorrichtung gemäß einem vierten Ausführungsbeispiel der vorliegenden Erfindung;
- Fig. 15: eine schematische Schnittansicht einer optischen Abbildungsvorrichtung gemäß einem fünften Ausführungsbeispiel der vorliegenden Erfindung.

### Detaillierte Beschreibung der Ausführungsbeispiele

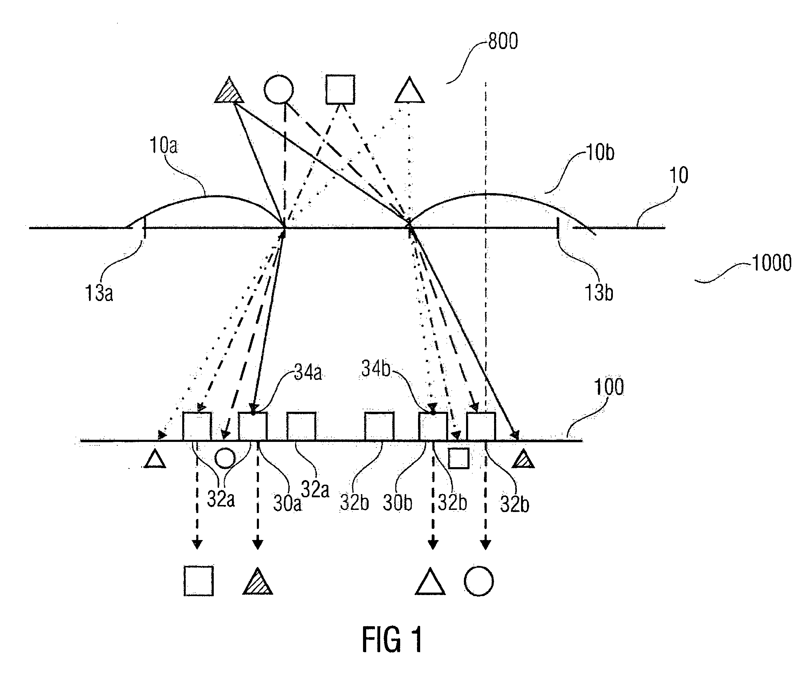

Fig. 1 zeigt eine schematische Darstellung einer optischen Abbildungsvorrichtung 1000 gemäß einem ersten Ausführungsbeispiel der vorliegenden Erfindung. Die optische Abbildungsvorrichtung 1000 umfasst ein Mikrolinsenfeld 10 mit einer ersten Mikrolinse 10a und einer zweiten Mikrolinse 10b. Unter dem Mikrolinsenfeld 10 befindet sich ein Bildsensor 100. Dieser Bildsensor 100 umfasst eine erste Bilddetektorenmatrize 30a und eine zweite Bilddetektorenmatrize 30b. Jede der beiden Bilddetektorenmatrizen 30a und 30b umfasst eine Mehrzahl von beispielsweise drei Bilddetektoren 32a, 32b. Die erste Mikrolinse 10a ist der ersten Bilddetektorenmatrize 30a zugeordnet und bildet mit dieser einen ersten optischen Kanal, die zweite Mikrolinse 10b ist der zweiten Bilddetektorenmatrize 30b zugeordnet und bildet mit dieser einen zweiten optischen Kanal. Die Mittelpunkte 34a und 34b der Bilddetektorenmatrizen 30a und 30b sind lateral versetzt, gegenüber auf die Bilddetektorenmatrizen 30a und 30b projizierten Flächenschwerpunkten der Mikrolinsenaperturen 13a und 13b der zugeordneten Mikrolinse 10a und 10b bzw. der zugeordneten optischen Kanäle.

Ausgehend von der strukturellen Beschreibung der optischen Abbildungsvorrichtung 1000 gemäß dem ersten Ausführungsbeispiels der vorliegenden Erfindung wird nun die Funktionsweise erläutert. Ein Objekt 800 wird durch die beiden Mikrolinsen 10a und 10b auf die jeweils zugeordneten Bilddetektorenmatrizen 30a und 30b abgebildet. Der erste optische Kanal und der zweite optische Kanal überlappen sich in ihren Erfassungsbereichen. Aufgrund der lateralen Verschiebung der Mittelpunkte 34a und 34b der Bilddetektorenmatrizen 30a und 30b zu den Mikrolinsen 10a und 10b wird der Überlappbereich der beiden Erfassungsbereiche versetzt auf die Bilddetektoren der Bilddetektorenmatrizen 30a und 30b abgebildet.

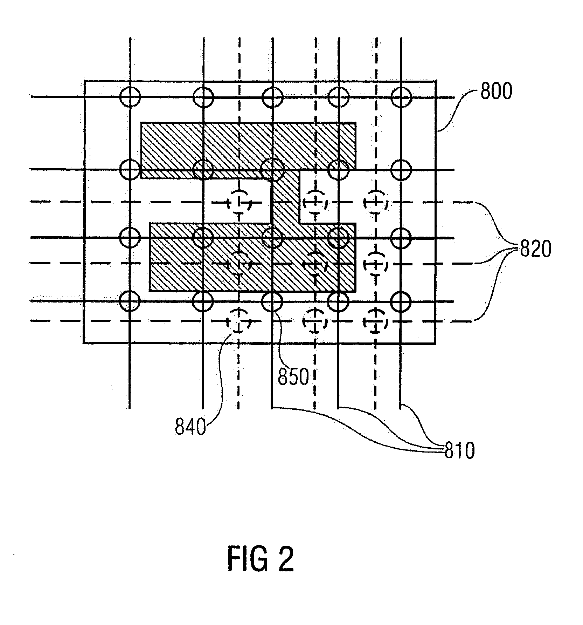

Zusätzlich ist jedem optischen Kanal ein Abtastgitter zugeordnet (siehe Fig. 2) wobei ein Abtastgitter 810 des ersten optischen Kanals beschreibt, welche Objektpunkte eines Objekts 800 auf welchen Bilddetektoren der Bilddetektorenmatrize 30a, des ersten optischen Kanals, abgebildet werden und wobei ein Abtastgitter 820 des zweiten optischen Kanals beschreibt, welche Objektpunkte des Objekts 800 auf welche Bilddetektoren der Bilddetektorenmatrize 30b, des zweiten optischen Kanals, abgebildet werden.

Fig. 2 zeigt eine Oberfläche des Objekts 800 mit dem Abtastgitter 810 des ersten optischen Kanals und dem Abtastgitter 820 des zweiten optischen Kanals. Das Abtastgitter 810 ist mit durchgezogenen Linien dargestellt, das Abtastgitter 820 ist mit gestrichelten Linien dargestellt. Die Kreuzungspunkte der durchgezogenen Linien beschreiben die Objektzellen des Objektes welche auf die Bilddetektoren der Bilddetektorenmatrize 30a, des ersten optischen Kanals abgebildet werden. Die Kreuzungspunkte der gestrichelten Linien beschreiben die Objektzellen des Objektes welche auf die Bilddetektoren der Bilddetektorenmatrize 30b, des zweiten optischen Kanals abgebildet werden.

Die Abtastgitter so gewählt sind, dass eine erste Objektzelle 840 des Objektes 800 auf einen ersten Bilddetektor der Bilddetektorenmatrize 30a des ersten optischen Kanals abgebildet wird und eine zweite, der ersten Objektzelle 840 benachbarte, Objektzelle 850 auf einen ersten Bilddetektor der zweiten Bilddetektoremnatrize 30b des zweiten optischen Kanals abgebildet wird. Durch diese ,,Verschränkung" der optischen Kanäle lässt sich eine höhere Bildauflösung als bei bisher bekannten künstlichen Facettenaugenprinzipien erzielen.

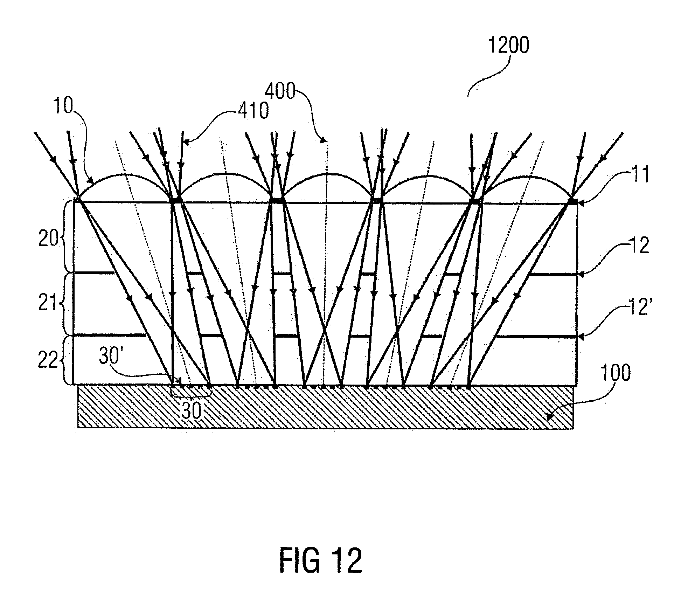

Im folgenden werden weitere Ausführungsbeispiele der vorliegenden Erfindung anhand der Figuren 12-15 näher erläutert.

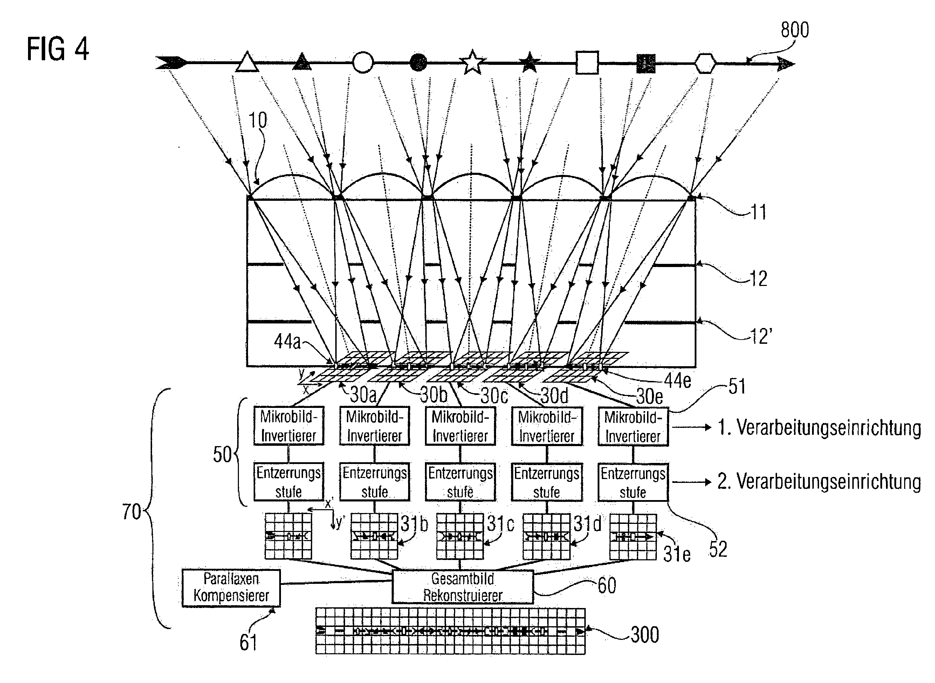

Die mehrkanaligen mikrooptischen Abbildungs- und Bildaufnahmesysteme gemäß den Ausführungsbeispielen gemäß der Figuren 12-15 haben die folgenden Eigenschaften gemein, alle bestehen aus einem oder mehreren axial hintereinander angebrachten Mikrolinsenfeldern 10, welche auf einem Stapel mehrerer zumindest teilweise transparenter Substratschichten 20, 21, 22 und/oder Abstandshalterschichten 40 abgeformt sind. Der ganze Schichtstapel ist so auf einem optoelektronischen Bildsensor 100 angebracht, dass sich dieser in der Brennweite (bzw. Bildebene oder Brennebene) der Mikrolinse des Mikrolinsenfeldes 10 befindet. Der optoelektronische Bildsensor wird im Folgenden auch kurz als "Bildsensor" oder "Bildsensorchip" bezeichnet. Zwischen dem Mikrolinsenfeld 10 und dem optoelektronischen Bildsensor 100 befindet sich mindestens eine lendenfeldschicht (12, 12') mit transparenten Öffnungen und lichtundurchlässigen (das heißt, absorbierenden oder reflektierenden) Zwischenräumen. Eine weitere Eigenschaft ist, dass zugeordnet zu jeder Mikrolinse aus dem Mikrolinsenfeld 10 eine Matrize von mindestens 5 x 5 dicht gepackten Bilddetektoren (also eine Bilddetektorenmatrize) 30 des optoelektronischen Bildsensors 100 zur Auslese des in jedem Kanal entstehenden Mikrobildes verwendet wird. Die Bildauslese beinhaltet in diesem Fall die Umwandlung der auftretenden elektromagnetischen Strahlung (Licht) in elektrische Photoströme. Diese werden Photodiode für Photodiode (pixelweise) in Zeilen und Spalten geordnet ausgelesen, wobei die Bildauflösung dabei auf die Größe und Anzahl der Photodioden begrenzt ist. Da in jedem Kanal eine einfache optische Abbildung entsteht, steht jedes Mikrobild für sich auf dem Kopf und ist seitenverkehrt (siehe Mikrobilder 44a bis 44e in Fig. 4). Außerdem ist die mittlere Blickrichtung 400 jedes Kanals (also die Verbindungslinie zwischen dem Scheitelpunkt der Mikrolinse und dem Mittelpunkt der zugeordneten Bilddetektorenmatrize 30) sowie die Größe des insgesamt aufgespannten Gesichtsfeldes durch einen Zentrumsversatz von der jeweiligen Mikrolinse zur zugeordneten Bilddetektorenmatrize 30 bzw. durch den Versatz des Mittelpunktes der Bilddetektorenmatrize 30, gegenüber dem auf die Bilddetektorenmatrize 30 projizierten Flächenschwerpunkt der Mikrolinsenapertur des zugeordneten optischen Kanals bzw. der zugeordneten Mikrolinse beschrieben. Weiterhin bestimmt die Ausdehnung der jeweiligen Bilddetektorenmatrize 30 zusammen mit der Brennweite der Mikrolinse den Bereich des Objektfeldes der im jeweiligen Kanal übertragen wird.

Weiterhin verhindert mindestens ein Aperturblendenfeld 11 das Licht durch die Zwischenräume des Mikrolinsenfeldes hindurch tritt und als Streulicht den Bildsensor 100 erreicht. Dies würde sonst den Bildkontrast verringern.

Die Verwendung von Kanalseparationsstrukturen (beispielsweise horizontale Blendenlagen oder vertikale oder schräge absorbierende Wände) ist empfehlenswert (in manchen Fällen sogar essentiell) um optisches Übersprechen, also Licht welches von einer Mikrolinse in den Bereich des Mikrobildes des Nachbarkanals (oder gar weiter entfernten Kanälen) abbildet, zu vermeiden. Optisches Übersprechen führt zur Überlagerung von Lichtbündeln, welche von unterschiedlichen Objektpunkten ausgehen, auf ein und demselben Bildpunkt, so dass sich der Bildkontrast verringert. Da jeder optische Kanal von den übrigen unabhängig funktioniert, ist es vorteilhaft, auch die zu den jeweiligen Mikrobildern gehörenden Bereiche 30 des optoelektronischen Bildsensors 100 in entsprechende Kanäle zu gliedern. Dies kann einerseits durch die physische Untergliederung der Auslesebereiche des Photodiodenfeldes durch eine auf dem Chip des Bildsensors 100 integrierte Elektronik (beispielsweise kanalweise getrennte Schaltkreise, SoC = "System on a Chip" ="System auf einem Chip") oder auch außerhalb des Halbleiterchips durch die entsprechend getrennte Weiterverarbeitung der Daten (in Peripherie beispielsweise auf einem FPGA oder sogar durch Software auf einem PC), die jeweils ein Mikrobild repräsentieren, erreicht werden. Für die erste Methode (physische Untergliederung auf dem Chip des Bildsensors) muss ein speziell für das Objektiv angepasster Bildsensor verwendet werden. Im Gegensatz dazu kann für die zweite Methode ein konventioneller Bildsensor mit entsprechend angepasster, nachgeschalteter Bildverarbeitungshard- und/oder Software verwendet werden. Dabei bleiben jedoch die aktiven Pixel in den Zwischenräumen zwischen den Mikrobildern auf dem konventionellen Bildsensor unbeleuchtet und ungenutzt. Sie können höchstens zur Korrektur von Dunkelstromrauschen dienen.

Die ausgelesenen Signale der Mikrobilder der benachbarten Kanäle können in Hard- oder Software miteinander zum Gesamtbild verrechnet werden (beispielsweise durch den Gesamtbild-Rekonstruierer 60 gemäß Fig. 4). Eine aktive Fokussierungseinrichtung der einzelnen Mikrobilder ist aufgrund der kurzen Brennweite der Mikrolinse und der damit verbundenen großen Schärfentiefe (bzw. Tiefenschärfe) nicht notwendig. Außerdem kann das Oberflächenprofil jeder einzelnen Mikrolinse des Mikrolinsenfeldes 10 für ihren mittleren Einfallswinkel (speziell auf Bildfeldwölbung und Astigmatismus) korrigiert werden. Dies geschieht durch die individuelle Anpassung der Brennweite in tangentialer und sagittaler Richtung, so dass die entsprechenden Bildschalen in der Mitte des Mikrobildes in der Bildebene zusammenfallen. Durch diese Anpassung entstehen von der Rotationssymmetrie abweichende (anamorphotische) Profile der Mikrolinse im jeweiligen Mikrolinsenfeld.

Die mehrkanaligen Abbildungsobjektive (Mikrolinsenfeld, Abstandshalterschichten und Aperturblenden) können vorteilhaft mittels mikrooptischer Herstellungsmethoden (UV-Lithographie, Schmelzprozesse (Rückflussverfahren bzw. "Reflow" und UV-Abformung oder auch Laserschreiben, Grauton oder Zweiphotonenlithographie) erzeugt werden. Dabei ist die axiale Positoniergenauigkeit des mikrooptischen Objektives sehr hoch, da es direkt und flächig auf den optoelektronischen Bildsensor montiert werden kann. Die axialen Toleranzen sind demnach durch die Schichtdickentoleranzen (im µm-Bereich) gegeben. Laterale Montagetoleranzen werden durch die Genauigkeit der Masken, Justiermarken und der Justagevorrichtung im jeweiligen Maskenausrichter (Mask Aligner) bestimmt. Sie betragen wenige µm (z. B. 1 - 2 µm).

Gemäß einem Aspekt der Erfindung unterscheidet sich die optische Abbildungsvorrichtung gemäß der vorliegenden Erfindung von dem Stand der Technik auf dem Gebiet künstlicher Facettenaugen, wie z. B. in DE 10 2004 003 013.8 und WO 2005/069607 beschrieben werden, unter anderem durch die Verwendung einer Vielzahl von Pixel pro Kanal und die Abbildung kleiner Mikrobilder, die anschließend zu einem Gesamtbild verrechnet werden. Statt eines eng begrenzten Bereichs des Objektfeldes erfasst jeder Kanal ein im Vergleich zu DE 10 2004 003 013.8 und WO 2005/069607 um ein Vielfaches größeres Objektfeld. In jedem Kanal wird somit ein pixelliertes Mikrobild eines ausgedehnten Objektfeldbereiches erfasst. Die pixellierten Mikrobilder der verschiedenen Kanäle sind miteinander verschränkt so dass ein höheres Gesamtauflösungsvermögen ermöglicht wird. Weiterhin ermöglicht die Nutzung einer Vielzahl von Pixeln pro Kanal die Nutzung größerer, einfacher herzustellender Mikrolinsen.

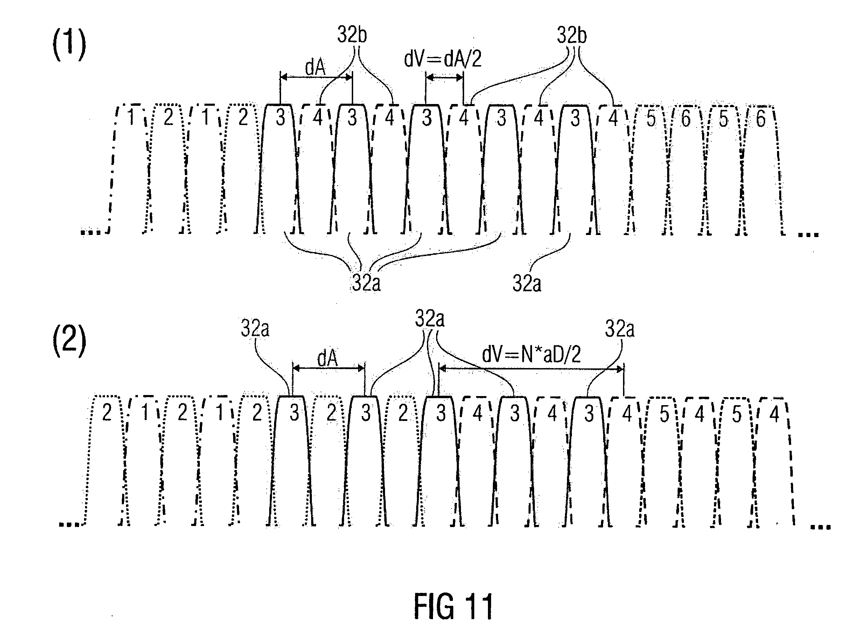

Die von den einzelnen Kanälen erfassten Bereiche des Objektfeldes können sich teilweise überlappen und dennoch sind die auf die einzelnen Pixel der Photodiodengruppen abgebildeten Objekte vorwiegend disjunkt. Der Grund dafür ist, dass die Abtastgitter benachbarter Kanäle in nicht ganzzahligen Vielfachen des Abtastintervalls (Abstand zwischen zwei benachbarten Linien des Abtastgitters) des Einzelkanals gegeneinander verschoben sind, wodurch eine dichte Objektfeldabtastung im Zusammenspiel benachbarter Kanäle trotz der kurzen Brennweite der Mikrolinsen und der festen Größe der Photodioden ermöglicht wird. Insbesondere seien hier zwei Fälle für die Verschiebung der Abtastgitter benachbarter Kanäle genannt. Fig. 11 zeigt diese beiden Fälle schematisch. Der im Objektfeld durch eine Photodiode des optoelektronischen Bildsensors einer optischen Abbildungsvorrichtung gemäß eines Ausführungsbeispiels der vorliegenden Erfindung abgetastete (bzw. erfasste) zweidimensionale Bereich ist im Querschnitt durch eine Kastenfunktion dargestellt. Der Linienstil sowie die Zahlen kennzeichnen die Zuordnung der Abtastbereiche zu den jeweiligen Kanälen. Ohne Beschränkung der Allgemeinheit sind hier jeweils fünf Photodioden (beispielsweise fünf Photodioden 32a für den dritten Kanal und fünf Photodioden 32b für den vierten Kanal) pro Kanal (N = 5 mit N: Anzahl der Abtastbereiche, bzw. Photodioden pro Kanal) dargestellt.

Photodioden des ersten Kanals sind mit der Nummer 1 versehen und durch eine Strichpunkt-Linie dargestellt. Photodioden des zweiten Kanals sind mit der Nummer 2 versehen und durch eine kurzgestrichelte Linie dargestellt. Die Photodioden 32a des dritten Kanals sind mit der Nummer 3 versehen und durch eine durchgezogene Linie dargestellt. Die Photodioden 32b des vierten Kanals sind it der Nummer 4 versehen und durch eine weit gestrichelte Linie dargestellt. Photodioden des fünften Kanals sind mit der Nummer 5 versehen und durch eine enggestrichelte Linie dargestellt. Photodioden des sechsten Kanals sind mit der Nummer 6 versehen und eine eitgestrichelte Linie dargestellt. Benachbarte Photodioden verschiedener Kanäle erfassen benachbarte Objektzellen des von der optischen Abbildungsvorrichtung erfassten Objekts.

In Fall 1 sind die Abtastgitter jeweils zweier benachbarter Kanäle um die Hälfte des Abtastintervalls dA eines Einzelkanals gegeneinander verschoben (Verschiebung: dV) Die Verschiebung dV des Abtastgitters eines der Kanäle des betrachteten Paares zum jeweils nächsten Kanal eines benachbarten Paares beträgt ein nichtganzzahliges Vielfaches des Abtastintervalls im Einzelkanal (beispielsweise (N-1/2) x dA , wobei N eine ganze Zahl ist). Dieser Fall ist für eine geringe Anzahl von optischen Kanälen (z. B. 2 x 2 Kanäle) oder auch für kleinere Objektabstände (kleiner 50 x Brennweite) relevant, um eine lückenlose äquidistante Abtastung des Objektfeldes zu gewährleisten. Mit anderen Worten gesagt, findet eine Verschiebung um ein ungerades Vielfaches der Hälfte des Abtastintervalls eines Einzelkanals statt.

Fall 2 zeigt eine Verschiebung dV der optischen Kanäle bzw. der Mittelpunkte der Photodektorenmatrizen der optischen Kanäle um die Hälfte der Gesamtsumme aller Abtastintervalle (N x dA) innerhalb eines Kanals bzw. um die Hälfte des Produktes aus der Anzahl (N) der Photodioden und dem Abtastintervall (dA) eines optischen Kanals (beispielsweise N x dA/2), bei gleichzeitiger ungerader Anzahl der Photodioden bzw. Abtastbereiche pro Kanal (N). Dieser Fall ist für eine größere Anzahl von Kanälen relevant, um die Abtastperiode im Zusammenspiel benachbarter Kanäle zu halbieren und dabei weder Abtastlücken noch Mehrfachabtastung zu erhalten. Diese Eigenschaft hat mehrere Vorteile. Ein erster Vorteil ist, dass eine Verkürzung (z. B. Halbierung) der Baulänge (selbst für das mehrkanalige System) bei gleich bleibender Winkelabtastung ermöglicht ist. Das bedeutet, der rückwärtig durch die Optik projizierte Winkelabstand zwischen zwei benachbarten Bildpixeln des Gesamtbildes bleibt erhalten. Dies gilt unter der Annahme gleicher Blendenzahl (F/#) und gleicher Größe der Photodioden bezüglich des Stands der Technik. Aus der Verringerung der Baulänge bzw. Brennweite der Mikrolinsen ergibt sich die Verkleinerung des Mikrolinsendurchmessers um eine konstante Blendenzahl (F/# = Brennweite Mikrolinse/Durchmesser Mikrolinse) zu erhalten. Die resultierende Verringerung der lateralen Abmaße des Objektivs führt zu einer Kostenreduktion, da ein optoelektronischer Bildsensor mit kleinerer Grundfläche verwendet werden kann. Ein weiterer Vorteil ist die erhöhte Empfindlichkeit bei gleich bleibender Winkelabtastung, da mit einer kürzeren Brennweite der Mikrolinsen auf die gleichgroße Photodiode abgebildet wird. Da durch die Verkürzung der Brennweite, im Vergleich zu bekannten Systemen, bei gleich bleibender Größe der Photodiode das Winkelauflösungsvermögen reduziert wird, kann, um zusätzlich die Winkelauflösung konstant zu halten, ein optoelektronischer Bildsensor mit entsprechend kleineren Photodioden verwendet werden, wobei die Empfindlichkeit der jeweiligen Photodioden reduziert gegenüber größeren Photodioden ist.

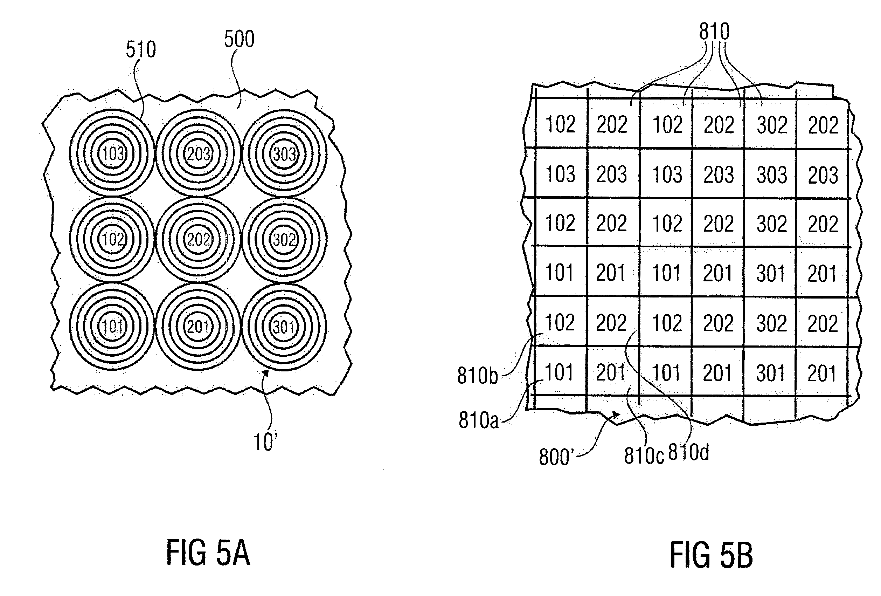

Zur Verdeutlichung der Verschränkung der einzelnen optischen Kanäle zeigt Fig. 5a eine schematische Draufsicht auf einen Teilbereich 500 eines optischen Abbildungssystems gemäß einem Ausführungsbeispiel der vorliegenden Erfindung mit den durch Ziffern gekennzeichneten Einzelkanälen 10', Mit anderen Worten zeigt Fig. 5a eine beispielhafte Anordnung für das Mikrolinsenfeld 10' wie es in den in Fig. 12-15 gezeigten Ausführungsbeispielen angeordnet bzw. ausgerichtet sein kann. Jedem optischen Kanal des optischen Abbildungssystems ist genau eine Mikrolinse 101-103; 201-203; 301-303 zugeordnet, welche in dem Mikrolinsenfeld 10' angeordnet ist. Das Profil der Mikrolinsen 101-103; 201-203; 301-303 wird durch Höhenlinien 510 dargestellt.

Fig. 5B zeigt eine vereinfachte Darstellung eines von diesem Teilbereich beobachteten Objektfeldbereichs 800'. Der Objektfeldbereich 800' ist in Zellen 810 eingeteilt, die jeweils auf eine Photodiode innerhalb eines Einzelkanals 10' (durch eine zum Kanal zugeordnete Mikrolinse 101-103; 201-203; 301-303) abgebildet werden. Zur Verdeutlichung der ineinander verschränkten Abtastgitter der Einzelkanäle ist jede Objektzelle mit der Kennziffer des jeweiligen Kanals 10' (bzw. der Mikrolinse 101-103; 201-203; 301-303) bezeichnet, der diese Zelle erfasst. Folglich zu sehen ist hier, dass benachbarte Objektzellen von Photodioden benachbarter optischer Kanäle (bzw. Mikrolinsen 101-103; 201-203; 301-303) erfasst werden. Aufgrund der Verschränkung der optischen Kanäle ist es möglich, dass die Abtastlücken eines optischen Kanals durch einen benachbarten optischen Kanal erfasst werden.

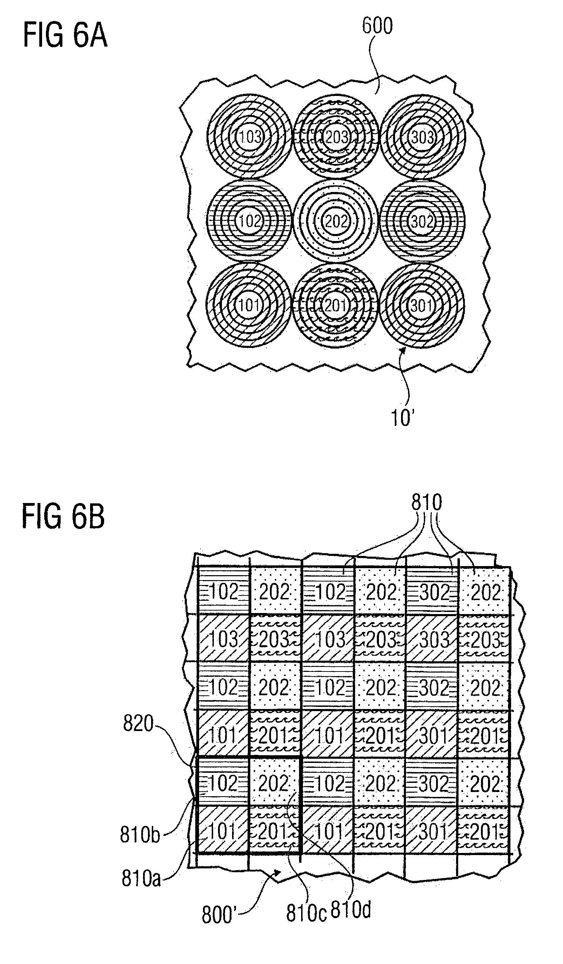

Weiterhin ist es möglich, dass mit einem weiteren Ausführungsbeispiel der vorliegenden Erfindung eine multispektrale Bildaufnahme (z. B. Farbbildaufnahme) durchgeführt werden kann, wobei die dazu notwendigen spektralen Transmissionsfilter einerseits pixelweise, das heißt auf den einzelnen Photodioden des optoelektronischen Bildsensors (z. B. Anordnung im bekannten "Bayer-Mosaik") oder kanalweise, beispielsweise innerhalb des Mikrolinsenobjektives oder auf dem zugeordneten Bildsensorbereich, integriert werden können. Die kanalweise Integration des spektralen Filters hat dabei gegenüber einem konventionellen Einkanalabbildungssystem den Vorteil, dass die Optik zusätzlich zu der Korrektur für den kanalspezifischen Einfallswinkel auch bezüglich der kanalspezifischen transmittierten Spektralverteilung angepasst werden kann. Außerdem tritt in dieser Konfiguration kein Farbübersprechen zwischen benachbarten Photodioden auf. Daraus ergibt sich beispielsweise eine höhere Farbbrillanz des Bildes bei Verwendung von Farbfiltern im visuellen Spektrum (z. B. Rot, Grün, Blau). Des Weiteren wird die Baulänge des optischen Abbildungssystems verkürzt. Um bei der Variante der kanalweisen Integration der Filter eine gleichmäßige Abtastung des Objektfeldes für alle verschiedenen spektralen Anteile zu gewährleisten, wird ein Abtastungsschema entsprechend Fig. 4 und den Fig. 6A und 6B verwendet.

Fig. 6A zeigt eine schematische Draufsicht auf einen Teilbereich 600 einer optischen Abbildungsvorrichtung gemäß einem Ausführungsbeispiel der vorliegenden Erfindung mit den durch Ziffern gekennzeichneten Einzelkanälen (10') und kanalweise integrierten spektralen Transmissionsfiltern (Flächenmuster). Die in Fig. 6A gezeigte Draufsicht auf die optische Abbildungsvorrichtung unterscheidet sich damit nur durch die spektralen Transmissionsfiltern auf den optischen Kanälen bzw, den Mikrolinsen 101-103; 201-203; 301-303. Wobei jedes Flächenmuster genau einen spektralen Transmissionsfilter zugeordnet wird, und damit jeder Kanal genau einer Spektralfarbe zugeordnet wird. Um eine gleichmäßige Abtastung des Objektfeldes für alle verschiedenen spektralen Anteile zu gewährleisten, können verschiedene optische Kanäle die gleichen spektralen Transmissionsfilter besitzen. In Fig. 6A besitzen die Kanäle 101, 103, 301, 303 ein schräg verlaufendes Linien-Flächenmuster und damit ein erstes Transmissionsfilter (beispielsweise für die Farbe Rot), die Kanäle 102 und 302 besitzen ein gerade verlaufendes Linien-Flächenmuster und damit ein zweites Transmissionsfilter (beispielsweise Grün), die Kanäle 201 und 202 besitzen ein gewelltes Linien-Flächenmuster und damit ein drittes Transmissionsfilter (beispielsweise für die Farbe Blau) und der Kanal 202 besitzt ein gepunktetes Flächenmuster und damit einen vierten Transmissionsfilter (beispielsweise einen Graufilter).

Fig. 6B zeigt eine vereinfachte Darstellung eines von diesem Teilbereich 600 aus Fig. 6A beobachteten Objektfeldbereiches 800'. Der Objektfeldbereich 800' ist in Objektzellen 810 eingeteilt, wobei eine Objektzelle 810 jeweils (zumindest im Wesentlichen) auf eine Photodiode innerhalb eines Einzelkanals 10' abgebildet wird. Zur Verdeutlichung der ineinander verschränkten Abtastgitter der Einzelkanäle 101-103; 201-203; 301-303 sowie der Abdeckung der Objektzellen 810 durch die jeweiligen Transmissionsfilter, ist jede Objektzelle mit der Kennziffer 101-103; 201-203; 301-303 des jeweiligen Kanals 10' und des Filtermusters (schräg verlaufende Linien, gerade verlaufende Linien, wellige Linien, gepunktet) versehen. Benachbarte Objektzellen 810 werden aufgrund der Abtastgitter, welche im objektseitigen Tiefenschärfebereich der Abbildungsvorrichtung liegen, von benachbarten optischen Kanälen 101-103; 201-203; 301-303 erfasst. Deutlich wird, dass die von benachbarten Kanälen (beispielsweise 101,102,201,202) erfassten Bereiche des Objektfeldes sich teilweise so überlappen, dass jeweils direkt benachbarte Bildinformationen (beispielsweise 810a, 810b, 810c, 810d) im zusammen gesetzten Gesamtbild durch unterschiedliche spektrale Transmissionsfilter (beispielsweise Rotfilter, Grünfilter, Blaufilter, Graufilter) erhalten werden bzw. so gefiltert werden um Spektraldaten zu erhalten. Die 4 direkt benachbarten Bereiche 810a, 810b, 810c, 810d des Objektfeldes 800' bilden beispielsweise eine Gruppe 820 welche alle 4 Transmissionsfilter umfasst.

Die multispektralen Daten (z. B. ein Grauwert pro Farbe) eines jeweiligen Bildpixels bzw. einer Bildinformation (beispielsweise 810a) können durch die gewichtete Interpolation aus dem physisch aufgenommenen Wert des zugeordneten Spektralbereichs bzw. der Bildinformation (beispielsweise 810a) und den Werten der übrigen Spektralbereiche bzw. der Bildinformationen (beispielsweise 810b, 810c, 810c) der benachbarten und/oder umliegenden Pixel (beispielsweise 810b, 810c, 810c) interpoliert werden, wobei jedem Pixel ein Spektralbereich bzw. ein Transmissionsfilter zugeordnet ist. Die Variante der kanalweisen Integration der spektralen Transmissionsfilter, d.h. jeder Kanal umfasst ein eigenes Transmissionsfilter, wobei benachbarte Kanäle vorzugsweise verschiedene Transmissionsfilter umfassen, hat im Gegensatz zur Integration der spektralen Transmissionsfilter auf jede einzelne Photodiode den Vorteil, dass größere Transmissionsfilter verwendet werden können, welche in der Herstellung einfacher zu handhaben sind. Für die hier gezeigte Variante können die kanalweisen spektralen Transmissionsfilter auch auf dem Bildsensorbereich der jeweiligen Kanäle integriert sein.

Fig. 12 zeigt eine optische Abbildungsvorrichtung 1200 gemäß dem zweiten Ausführungsbeispiel der vorliegenden Erfindung. Die abbildenden Mikrolinsen 10 befinden sich in einer zweidimensionalen Feldanordnung (eindimensionale Anordnung ist auch möglich) auf einem Stapel transparenter oder zumindest teilweise transparenter Substratschichten 20, 21, 22 mit einer Gesamtschichtdicke, die der Brennweite der Mikrolinsen im jeweiligen Material (Glas, Kunststoff) entspricht. Auf der Rückseite der transparenten Substratschichten 20, 21, 22 befindet sich (beispielsweise in einer Brennebene der Mikrolinsen 10) der optoelektronische Bildsensor 100 mit einer Vielzahl von Photodioden 30', welche ebenfalls in einem zweidimensionalen Feld angeordnet sind. Die Photodioden 30' können entsprechend der Kanaleinteilung des Mikrolinsenfeldes ebenfalls in separate Gruppen von mindestens 5 x 5 Photodioden 30' für die jeweiligen Mikrobilder der Kanäle unterteilt sein, wobei diese Gruppen jeweils eine Bilddetektorenmatrize 30 bzw. ein Photodiodenfeld 30 bilden.

Unter dem Mikrolinsenfeld 10 befindet sich ein Aperturblendenfeld 11. Zwischen der Substratschicht 20 und der Substratschicht 21 befindet sich ein erstes Blendenfeld 12. Ein zweites Blendenfeld 12' befindet sich zwischen der Substratschicht 21 und der Substratschicht 22. An der Unterseite der Substratschicht 22 ist der Bildsensor 100 befestigt. Die Mittelpunkte der Bilddetektorenmatrizen 30 weisen einen Zentrumsversatz gegenüber den auf die Bilddetektorenmatrizen 30 projizierten Flächenschwerpunkten der Mikrolinsenaperturen der zugehörigen optischen Kanäle auf.

Ausgehend von der strukturellen Beschreibung wird nun die Funktion beschrieben. Die mittlere Blickrichtung 400 jedes Kanals ist durch den Versatz des Mittelpunktes der Bilddetektorenmatrize 30, gegenüber dem auf die Bilddetektorenmatrize 30 projizierten Flächenschwerpunkt der Mikrolinsenapertur des jeweiligen optischen Kanals beschrieben.

Die Ausdehnung der jeweiligen Bilddetektorenmatrizen 30 bestimmt, zusammen mit der Brennweite der Mikrolinsen, den Bereich des Objektfeldes, der im jeweiligen Kanal übertragen wird. Die von benachbarten Kanälen erfassten Bereiche des Objektfeldes können sich gegenseitig, zumindest teilweise, überlappen, wobei sich die zwei groben Abtastgitter der Kanäle jeweils zu einem dichteren neuen Abtastgitter ergänzen. Unter einem Abtastgitter eines betrachteten Kanals wird dabei beispielsweise die Gesamtheit derjenigen Objektpunkte in dem Tiefenschärfebereich (bzw. in einer Ebene in dem Tiefenschärfebereich) des betrachteten Kanals verstanden, die auf die einzelnen Bilddetektoren der Bilddetektorenmatrize 30 des betrachteten Kanals abgebildet werden. Die Fig. 2, 4 sowie 5A und 5B zeigen diese Eigenschaft, der Verschränktheit benachbarter Kanäle. Die Verwendung des Aperturblendenfelds 11 direkt unter dem Mikrolinsenfeld 10 erweist sich als vorteilhaft, um Streulicht zu unterdrücken, welches sonst durch die Zwischenräume der Mikrolinsen fallen würde. Des Weiteren werden die mindestens zwei horizontalen Blendenfelder 12 und 12', aus lichtundurchlässigen (absorbierendem oder reflektierendem) Material, verwendet, um optisches Übersprechen zwischen den Kanälen zu verhindern. Die transparenten Substratschichten 20, 21, 22 sind vorteilhaft aus Glas, Kunststoff oder anorganischen Co-Polymer (z. B. ORMOCER). Zusätzlich zu dem hier gezeigten kann eine feldartige Anordnung spektraler Transmissionsfilter (z. B. kanalweise Rot-, Grün-, Blaufilter) direkt zwischen der Blendenfeldschicht 11 und den Mikrolinsen 10 strukturiert sein, um eine multispektrale Bildaufnahme zu ermöglichen.

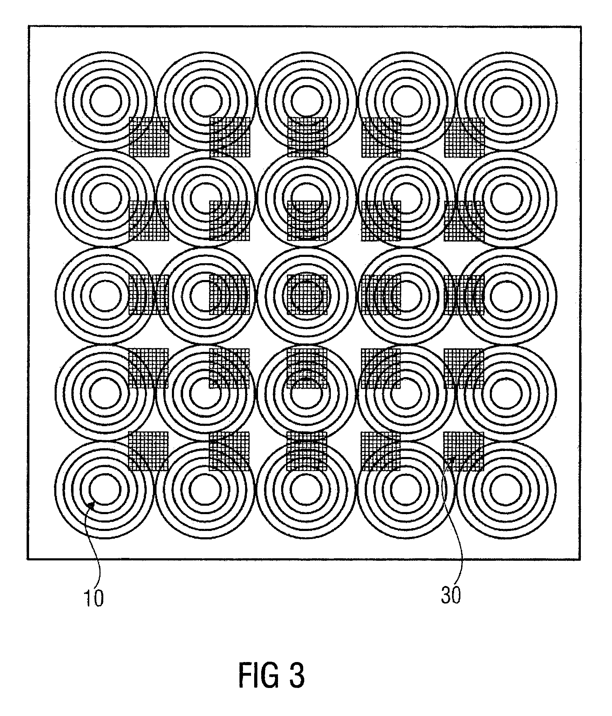

Das optische Abbildungsvorrichtung 1200 zeichnet sich durch ihren monolithischen Schichtaufbau und die damit verbundene vereinfachte Herstellungstechnologie und Stabilität aus. Die Optik kann getrennt vom optoelektronischen Bildsensor 100 hergestellt und im Folgeschritt mit diesem im Wafermaßstab (viele optische Systeme auf einem Wafer parallel zu vielen optoelektronischen Systemen auf einem anderen Wafer) mittels Justiermarken montiert werden. Alternativ können einzelne Optiken aus dem Optikwaferverbund ausgesägt und einzeln auf die jeweiligen optoelektronischen Bildsensoren montiert werden. Die Fixierung erfolgt, beispielsweise durch Kleben, Löten oder anodisches Bonden. Ebenfalls denkbar ist eine hybride Herstellungstechnik, bei der die Optikkomponenten schrittweise auf dem Optowafer mit der Vielzahl von Bildsensoren 100 aufgebaut werden. Zur Verdeutlichung des Versatzes der Mittelpunkte der Bilddetektorenmatrizen 30 bezüglich ihrer zugeordneten Mikrolinsen (bzw. gegenüber den auf die Bilddetektorenmatrizen 30 projizierten Flächenschwerpunkten der Mikrolinsenaperturen der zugehörigen optischen Kanäle bzw. der zugeordneten Mikrolinsen) ist in Fig. 3 eine vereinfachte schematische Draufsicht auf ein zweidimensionales Abbildungs- und Bildaufhahmesystem gemäß dem zweiten Ausführungsbeispiel dargestellt. Gezeigt sind hier die feldartig angeordneten Mikrolinsen 10, deren Profil durch Höhenlinien dargestellt ist, sowie die axial darunter liegenden, lateral (gegenüber den auf die Bilddetektorenmatrizen 30 projizierten Flächenschwerpunkte der Mikrolinsenaperturen der jeweiligen Kanäle bzw. der jeweiligen Mikrolinsen) versetzten Gruppen von Photodioden (Bilddetektorenmatrizen 30) des optoelektronischen Bildsensors 100.

Zusätzlich können das zweite Ausführungsbeispiel sowie alle anderen möglichen Ausführungsbeispiele der vorliegenden Erfindung, eine Einheit 70 zur kanalweisen elektronischen Vorverarbeitung der Signale der Mikrobilder umfassen. Diese kann wahlweise in den Schaltkreis des optoelektronischen Bildsensors 100 integriert sein, oder außerhalb des Bildsensors 100 nachgeschaltet sein.

Die Einheit 70 kann im Folgenden auch als "Bildverarbeitungsvorrichtung" bezeichnet werden.

Beispielhaft werden im Folgenden vier Varianten für eine Hardwareimplementierung der Bildverarbeitungsvorrichtung 70 zur kanalweisen elektronischen Vorverarbeitung der Signale der Mikrobilder in Zusammenhang mit der optischen Abbildungsvorrichtung gezeigt werden:
1. Die Bildverarbeitungsvorrichtung 70 befindet sich in der Peripherie außerhalb des opto-elektronischen Bildsensorchips 100 (beispielsweise ein FPGA der sich auf derselben Leiterplatte auf der sich der Bildsensorchip 100 befindet), also nicht auf dem Bildsensorchip 100 (englisch: "off-chip"). Der Bildsensorchip 100 besitzt dann wenige Ausgänge, die gesamte Bildmatrix (Gesamtheit aller durch die Bilddetektoren 30' der Bilddetektorenmatrizen 30 erfassten Bild-Informationen) wird ausgegeben und im Nachgang gemeinschaftlich verarbeitet (zeitlich seriell).
2. Die Bildverarbeitungsvorrichtung 70 befindet sich in der Peripherie außerhalb des optoelektronischen Bildsensorchips 100 aber der Bildsensor 100 besitzt eine Vielzahl von Ausgängen (mindestens in gleicher Anzahl wie Bilddetektorenmatrizen 30 vorliegen). Hier kann die Korrektur von Verzeichnung und weitere Bildvorverarbeitung für jedes Mikrobild getrennt und gegebenenfalls zeitlich parallel durchgeführt werden.
3. Die Bildverarbeitungsvorrichtung 70 befindet sich auf dem opto-elektronischen Bildsensorchip 100 (z.B. "ASIC" - Anwendungsspezifischer Integrierter Schaltkreis) aber außerhalb des fotoaktiven Flächenbereiches. Die gesamte Bildmatrix wird aus dem fotoaktiven Bereich innerhalb des Bildsensorchips 100 an die Bildverarbeitungsvorrichtung 70 übergeben und im Nachgang gemeinschaftlich verarbeitet (zeitlich seriell).
4. Die Bildverarbeitungsvorrichtung 70 befindet sich auf dem opto-elektronischen Bildsensorchip 100 (z.B. ASIC) und ein Teil, nämlich die Mikrobildverarbeitungseinrichtungen 50, befindet sich in den Zwischenräumen der Bilddetektorenmatrizen 30. In diesem Fall wird ein Teil der Bildverarbeitung für jede Bilddetektorenmatrize 30 bzw. Bilddetektormatrix 30 getrennt und zeitlich parallel durchgeführt. Au-βerdem wird durch die Integration der notwendigen Schaltkreise in den fotoaktiven Bereich Siliziumfläche eingespart. Das heißt die Mikrobildverarbeitung erfolgt für jede Bilddetektormatrix 30 bzw. Bilddetektorenmatrize 30 getrennt durch Mikrobildverarbeitungsvorrichtungen zwischen den Bilddetektorenmatrizen 30 und damit zeitlich parallel.

Die kanalweise Korrektur von Verzeichnung kann nur im Falle der Hardwareausführung der Bildverarbeitungsvorrichtung 70 (z.B. in einem FPGA, ASIC und Ähnlichem)" zeitlich parallel" durchgeführt werden. Die Eigenschaft "zeitlich parallel" ist somit optional. In Bezug auf eine hohe Bildwiederholrate ist diese Ausführungsform der Hardwareausführung daher bevorzugt, es kann jedoch auch eine software-basierte Korrektur (z.B. in einem angeschlossenen PC) durchgeführt werden.

Die Einheit 70 bzw. die Bildverarbeitungsvorrichtung 70 soll nun am Beispiel des zweiten Ausführungsbeispiels erklärt werden. Sie implementiert eine Hard- und/oder softwareimplementierte kanalweise elektronische Korrektur der Verzeichnung der Mikrobilder.

Aufgrund der Abbildung und des schrägen Lichteinfalls durch eine einfache Abbildungsoptik (z. B. einzelne Plan-konvexe Linse) treten mit steigendem Einfallswinkel (d. h. im äußeren Bereich des Objektfeldes) wachsende Bildverzerrungen (Verzeichnung) auf. Dies führt dazu, dass z. B. ein quadratischer Objektbereich unter schrägem Einfall in einen rautenförmigen Bildbereich abgebildet wird.

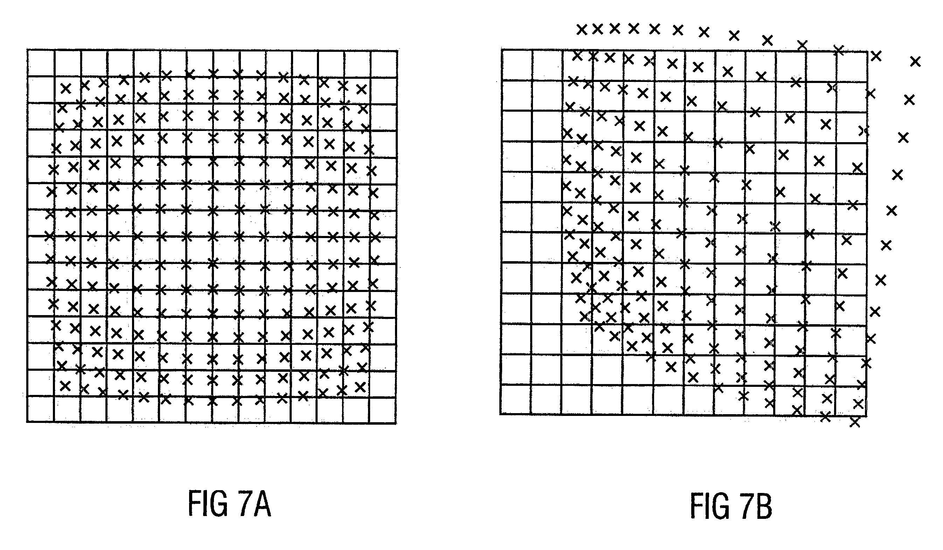

Fig. 7A zeigt eine qualitative Darstellung der Verzeichnung in einem zentralen Objektfeldbereich des zweiten Ausführungsbeispiels. Objektzellen, die sich in einem quadratischen Gitter befinden, werden unter schrägem Einfallswinkel zu kleineren radialen Bildkoordinaten abgebildet, es entsteht eine tonnenförmige Verzeichnung.

Fig. 7B zeigt, dass unter schrägem Einsatzwinkel (hier 38° diagonaler Winkel im Objektfeld) die Verzeichnung zusätzlich stark asymmetrisch wird. Die Effekte in den Fig. 7A und 7B sind zu Visualisierungszwecken verstärkt dargestellt.

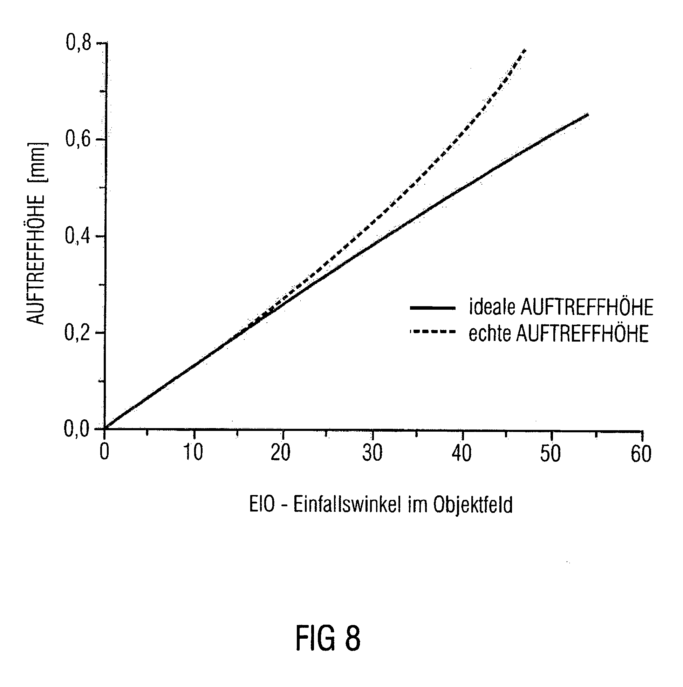

Fig. 8 zeigt den prinzipiellen Verlauf der positiven, tonnenförmigen Verzeichnung. Dies wird dargestellt durch die radiale Höhe des Hauptstrahls in der Bildebene ("echte Auftreffhöhe") in Abhängigkeit seines Einfallswinkels im Objektfeld (EIO = Einfallswinkel im Objektfeld, engl.: AOI = angle of incidence) im Vergleich mit der paraxialen, also ideal unverzeichneten, Auftreffhöhe ("ideale Auftreffhöhe"). Man erkennt deutlich, wie die Abbildung mit zunehmendem Einfallswinkel zu kleineren Auftreffhöhen tendiert. Da benachbarte Objektpunkte, welche auf die Mikrobilder verschiedener Kanäle abgebildet werden, wieder zu benachbarten Bildpunkten im Gesamtbild zusammengesetzt werden müssen, ist eine Entzerrung der Mikrobilder empfehlenswert. Ansonsten käme es in Folge der entsprechend dem Einfallswinkel wachsenden Verzeichnung für Kanäle bei denen die Mittelpunkte der Bilddetektorenmatrizen lateral verschoben gegenüber den auf die Bilddetektorenmatrizen 30 projizierten Flächenschwerpunkten der Mikrolinsenaperturen der jeweiligen Kanäle sind (sogenannte "off axis Kanäle" bzw. von der Achse entfernte Kanäle), zum Rand des Gesamtbildes hin vermehrt zu Versätzen zwischen den Bildinformationen und damit zum falschen Anschluss der Mikrobilder und reduzierter Auflösung. Die Signale der Mikrobilder werden durch eine Hard- und/oder Softwarekomponente entweder direkt im integrierten Schaltkreis (z. B. ASIC, SoC) oder nachgeschaltet (z. B: FPGA, CPU) gedreht und invertiert sowie entzerrt (das heißt: auf Verzeichnung korrigiert, beispielsweise durch einen Verzeichnungskorrigierer 50 gemäß Fig. 4). Innerhalb der gleichen Sequenz, mit anderen Worten durch den Verzeichnungskorrigierer 50 kann außerdem Dunkelstromrauschen ("fixed pattern noise) und die Inhomogenität der Beleuchtungsstärke ("shading") in den Mikrobildern korrigiert werden. Die Parallelisierbarkeit dieser Bildverarbeitung erlaubt (beispielsweise mittels eines anwendungsspezifischen Schaltkreises (ASIC)) eine kurze Rechenzeit und somit eine hohe Wiederholrate des Gesamtbildes.

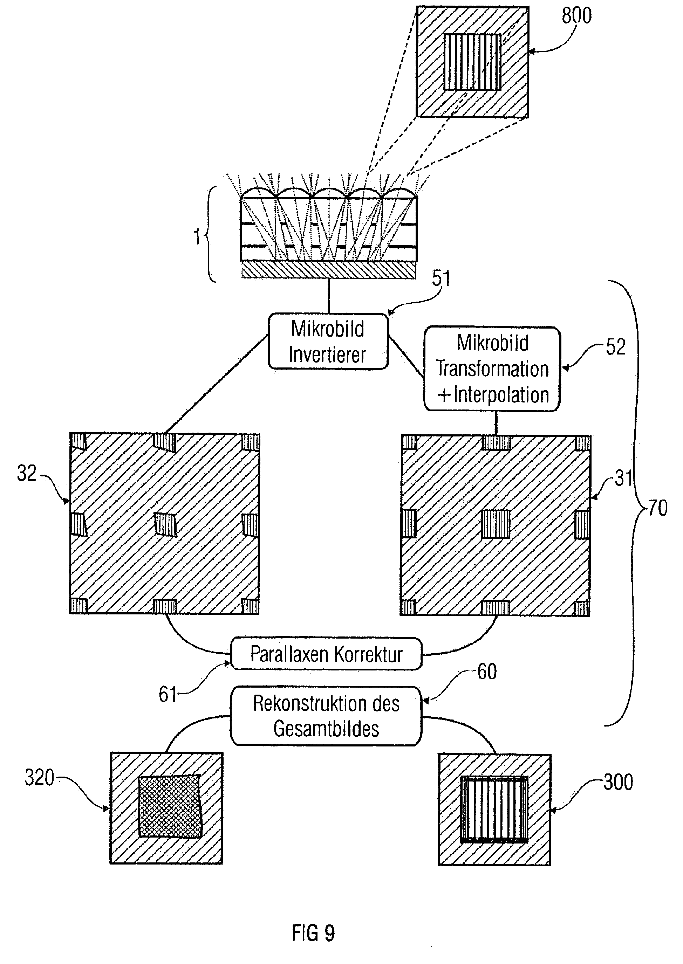

Die Einheit zur Korrektur der Verzeichnung und zum Zusammensetzen des Gesamtbildes aus den einzelnen Mikrobildern ist in Fig. 4 sowie Fig. 9 aufgezeigt und wird nun anhand dieser beiden Figuren detailliert erklärt.

Fig. 4 zeigt eine optische Abbildungsvorrichtung gemäß dem 2. Ausführungsbeispiel mit einer nachgeschalteten Einheit (50, 60, 61) zur Korrektur der Mikrobilder und zum Rekonstruieren des Gesamtbildes 300 aus den Mikrobildern. Ein im ausgedehnten Objektfeldbereich (beispielsweise im Tiefenschärfebereich) befindliches Objekt 800 wird entsprechend seiner Größe von verschiedenen Kanälen der optischen Abbildungsvorrichtung erfasst. Die durch die einzelnen Mikrolinsen des Mikrolinsenfeldes 10 abgebildeten Objektfeldbereiches überlappen sich gegenseitig zumindest teilweise. Dennoch sind die auf die Bilddetektorenmatrizen (30a bis 30e) abgebildeten Objektbereiche (44a bis 44e) vorwiegend disjunkt, das heißt Objektfeldbereiche (44a bis 44e) welche bereits auf eine Bilddetektorenmatrize (30a bis 30e) abgebildet sind werden bevorzugt auf keine weitere Bilddetektorenmatrize (30a bis 30e) abgebildet. Der Grund dafür ist, dass die Abtastgitter benachbarter Kanäle z. B. um die Hälfte der gesamten Summe aller Abtastbereiche (bei ungerader Anzahl der Abtastbereiche bzw. Photodioden) innerhalb eines Kanals gegeneinander verschoben sind, wodurch eine dichte Objektfeldabtastung trotz der kurzen Brennweite der Mikrolinsen 10 sowie der festen Größe der Photodioden 3 0' ermöglicht wird.

Fig. 4 zeigt weiterhin die schematische Darstellung der Bildvorverarbeitung mit einer Bildverarbeitungseinrichtung 70, die notwendig ist, um aus den aufgenommenen Mikrobildern der Pixelgruppen (30a bis 30e) ein vollständiges und unverzerrtes Bild 300 des gesamten Objektes 800 zu formen. Die einzelnen Mikrobilder 30a bis 30e werden in einer ersten Verarbeitungseinrichtung 51 ("Mikrobild-Invertierer") der Bildverarbeitungseinrichtung 70 horizontal und vertikal gespiegelt (entspricht Drehung um 180°). In einer zweiten Verarbeitungseinrichtung 52 ("Entzerrungsstufe") der Bildverarbeitungseinrichtung 70 werden die Pixelwerte der Mikrobilder aus ihrer diskreten Gitterstruktur mittels einer Ortstransformation (z. B. bi-lineare Transformation in x- und y-Koordinaten) auf eine kontinuierliche virtuelle Koordinatenebene umgerechnet. Die Transformationsparameter sind aus den optischen Designdaten sowie Simulationen bekannt, so dass Bildverzerrungen aufgrund von Perspektiven, Variationen des Abbildungsmaßstabes und Abbildungsfehlern korrigiert werden. Durch eine zusätzliche Interpolation werden die somit unverzerrten Pixelwerte kanalweise auf ein neues diskretes Gitter (x', y' in 31a bis 31e) abgebildet. Die in den Verarbeitungseinrichtungen 51 und 52 durchgeführten Verarbeitungsschritte können bevorzugt kanalweise und somit parallel durchgeführt. Bei Verwendung eines angepassten optoelektronischen Bildsensors 100 ist es für die Beschleunigung des Verarbeitungsprozesses vorteilhaft, die erste Verarbeitungseinrichtung 51 sowie die zweite Verarbeitungseinrichtung 52 innerhalb eines für jeden Kanal vorhandenen Schaltkreismoduls, direkt auf dem Chip des Bildsensors 100 (z. B. ASIC) zu integrieren. Für die Platzierungen der entsprechenden Schaltkreise bietet sich der optisch ungenutzte Zwischenraum zwischen den Bilddetektorenmatrizen 30 benachbarter Kanäle an. Die Fusion der Pixelwerte (bzw. Rekonstruktion des Gesamtbildes) aller Mikrobilder (31a bis 31e) findet wahlweise hardwarenah, also elektronisch in der Peripherie des Chips des optoelektronischen Bildsensors (z. B: FPGA), oder softwarenah, also erst innerhalb einer extern angeschlossenen CPU (z. B. PC), statt.

Die Fusion der Pixelwerte kann von einer dritten Verarbeitungseinrichtung 60 ("Gesamtbild-Rekonstruierer") der Bildverarbeitungseinrichtung 70 durchgerührt werden, welche die Umsortierung der Pixelwerte von den unverzerrten Mikrobildern 31 a bis 31 e in eine finale Bildmatrix 300 nach einem festen Muster durchführt, welches durch die Verschränkung der Abtastgitter der einzelnen Kanäle vorgegeben ist.

Fig. 9 zeigt eine schematische Darstellung der Verzerrung eines Bildes eines quadratischen Objektbereiches mit einem Gitterobjekt 800 in Folge von Verzeichnung bei der Abbildung unter schrägem Einfallswinkel. Die linke Seite zeigt die Rekonstruktion eines Gitterobjektes 800 als Vergleichsbeispiel ohne die zweite Verarbeitungseinrichtung 52 zur Verzeichnungskorrektur, die rechte Seite zeigt die Rekonstruktion des Gitterobjektes 800 mit der zweiten Verarbeitungseinrichtung 52 zur Verzeichnungskorrektur.

Auf der linken Seite ist die Bildaufnahmesequenz inklusive Abbildung durch das mehrkanalige Abbildungs- und Bildaufnahmesystem bzw. die optische Abbildungsvorrichtung und die nachfolgende Invertierung durch die Verarbeitungseinrichtung ("Mikrobild-Invertierer") 51 der Mikrobilder (hier 3 x 3 Stück) gezeigt. Die Mikrobilder 32 sind in Folge der fehlenden zweiten Verarbeitungseinrichtung ("Entzerrungsstufe") 52 immer noch verzeichnet. Es folgt die virtuelle Verschiebung (beispielsweise durch einen "Parallaxen-Kompensierer" 61 der Bildverarbeitungseinrichtung 70) der Mikrobilder 32 zueinander, um abhängig vom Objektabstand den Parallaxeversatz zu kompensieren und schließlich die Fusion der Pixelwerte durch die dritte Verarbeitungseinrichtung 60 aller Mikrobilder 32 zu einem Gesamtbild 320. Aufgrund der Verzeichnung können die Details der verschiedenen Mikrobilder nicht aneinander anschließen und das Objekt 800 wird durch das Gesamtbild 320 nicht hinreichend genau repräsentiert.

Im Gegensatz dazu ist auf der rechten Seite die Bildverarbeitungssequenz mit einer Stufe zur Korrektur der Verzeichnung (Entzerrungsstufe 52) dargestellt. Die dadurch transformierten Mikrobilder 31 sind unverzerrt und ergeben nach der Kompensation der Parallaxe durch den Parallaxen-Kompensierer 61 (virtuelle Verschiebung der Mikrobilder) und der Fusion der Pixelwerte aller Mikrobilder durch den Gesamtbild-Rekonstruierer 60 ein Gesamtbild 300, das eine hinreichend genaue Repräsentation des Objektes 800 darstellt.

Im Gegensatz zu dem System gemäß US 05696371A und EP 0840502A2 wird in dem Ausführungsbeispiel der Erfindung eine kanalweise Korrektur der Verzeichnung der Mikrobilder und eine Interpolation der Pixelwerte der Mikrobilder durchgeführt, somit wird das Auflösungsvermögen im Gesamtbild nicht durch die Segmentierung reduziert.

Um eine ordnungsgemäße Korrektur der Verzeichnung und Rekonstruktion der Mikrobilder zu einem Gesamtbild zu ermöglichen, ist eine elektronische Einstellung des Arbeitsabstandes im Objektraum verwendbar. Bei der Abtastung zweier benachbarter Objektpunkte aus zwei lateral beabstandeten Kanälen kommt es, aufgrund von Parallaxe zwischen den verschiedenen Kanälen, bei geringen Objektabständen zu einem Versatz der benachbarten Bildinformationen. Dieser Versatz kann durch eine ("virtuelle") Verschiebung der Teilbildinformationen korrigiert werden. Die Verschiebung ist dabei vom Objektabstand und der Basislänge zwischen den Kanälen (d.h. der Abstand zwischen den Mittelpunkten der Photodektektorenmatrizen der jeweiligen Kanäle) abhängig. Da die Basislänge bekannt ist, kann durch die Messung des Objektabstandes (z. B. mit einem dafür geeigneten unabhängigen Abstandsensor) der Versatz elektronisch nachkorrigiert werden. Das optische Abbildungs- und Bildaufnahmesystem stellt das Gesamtbild durch eine Variation des virtuellen Versatzes der Mikrobilder vor der Verrechnung (Fusion der Mikrobilder zu einem Gesamtbild) für die jeweilige Entfernung unverzerrt und scharf ein (beispielsweise durch den Parallaxen-Kompensierer 61 in Fig. 4).

Die Einstellung des Arbeitsabstandes erfolgt entsprechend der Anzahl der Bildpixel jedes Mikrobildes in diskreten Schritten. Da jedoch für die Entzerrung der Mikrobilder eine Koordinatentransformation (auf das unverzerrten Mikrobild) und eine Interpolation (der Signalstärke des unverzerrten Mikrobildes bei diskreten Pixelpositionen) notwendig ist, kann die Einstellung des Arbeitsabstandes mittels virtuellen Subpixelverschiebungen auch in feineren Abstufungen durchgeführt werden.

Mit anderen Worten gesagt, da bei kleinen Objektabständen (kleiner 100 x Brennweite) ein Blickwinkelversatz (Parallaxe) zwischen den teilweise überlappenden Objektfeldbereichen in benachbarten Mikrobildern auftritt, sollte dieser bei der Fusion der Mikrobilder berücksichtigt werden, um einen gleichmäßigen Anschluss der Mikrobilderdetails zu gewährleisten. Wenn der (mittlere) Objektabstand bekannt ist (er kann z.B. durch eine externe Sensorquelle im Parallaxen-Kompensierer 61, ähnlich wie bei einer Messsucherkamera, bestimmt werden), wird der Sortieralgorithmus im Gesamtbild-Rekonstruierer 60 (bei der Rekonstruktion des Gesamtbildes) variiert, indem die Mikrobilder der Einzelkanäle virtuell lateral entsprechend einer Wertetabelle zueinander versetzt werden. Dies kann in Stufung eines Pixels oder auch feiner durch eine Subpixelinterpolation geschehen. Am Rande des Gesamtbildes 300 kommt es aufgrund der verschränkten Abtastgitter zu "leeren Pixelwerten", da die zugehörigen Objektfeldzellen durch die fehlenden, jenseits des Randes des Mikrolinsenfeldes 10 befindlichen Nachbarkanäle erfasst würden.

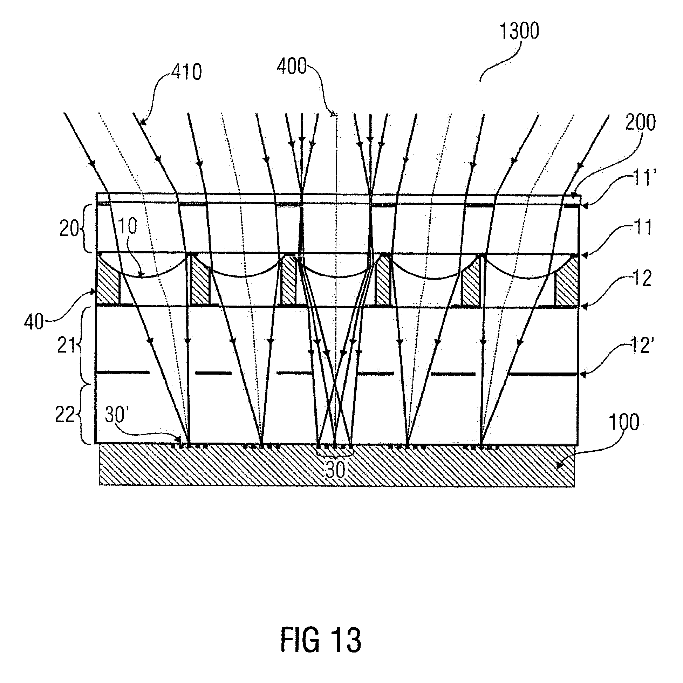

Fig. 13 zeigt eine optische Abbildungsvorrichtung 1300 gemäß eine dritten Ausführungsbeispiel der vorliegenden Erfindung. Die optische Abbildungsvorrichtung 1300 umfasst einen Bildsensor 100 mit beispielsweise fünf Bilddetektorenmatrizen 30. Auf der dem Objekt zugewandten Seite (bzw. oberhalb) des Bildsensor 100 befindet sich eine transparente Substratschicht 22, auf welcher sich ein erstes Blendenfeld 12' befindet. Oberhalb des ersten Blendenfeldes 12' befindet sich eine weitere transparente Substratschicht 21, oberhalb der sich ein zweites Blendenfeld 12 befindet. Eine Abstandshalterschicht 40 ist oberhalb dem zweiten Blendenfeld 12 angeordnet, kopfüber in dieser Abstandshalterschicht 40 sitzt das Mikrolinsenfeld 10, d.h. die planen Seiten der Mikrolinsen des Mikrolinsenfeldes 10 zeigen in Richtung des Objektes, während die gebogenen Seiten der Mikrolinsen in Richtung des Bildsensors 100 zeigt. Auf der Oberseite des Mikrolinsenfeldes 10 ist ein erstes Aperturblendenfeld 11 angeordnet. Oberhalb dem ersten Aperturblendenfeld 11 ist eine weitere Substratschicht 20 angeordnet, welche auf ihrer Oberseite ein zweites Aperturblendenfeld 11' hat. Oberhalb des zweiten Aperturblendenfeld 11' ist eine Filterschicht 200 angeordnet.

Im Folgenden werden nun die Funktion und die Vorteile der optischen Abbildungsvorrichtung 1300 gemäß dem dritten Ausführungsbeispiels erläutert. Da in der optischen Abbildungsvorrichtung 1300 das Mikrolinsenfeld 10 mit mindestens einer Substratschicht 20 kopfüber auf einem Abstandshalter 40 mit dem darunter liegendem Stapel aus transparenten Substratschichten 21, 22 aufgesetzt ist, kann dementsprechend das zweite Aperturblendenfeld 11' von den Linsen getrennt werden und sich auf der Frontseite der transparenten Substratschicht 20 befinden. Dies hat die folgenden Vorteile gegenüber der optischen Abbildungsvorrichtung 1200 gemäß dem zweiten Ausführungsbeispiel.

Ein erster Vorteil ist, dass durch die vorgelagerte Position des zweiten Aperturblendenfelds 11' in Verbindung mit einer Plan-Konvex-Linse sich optische Abbildungsfehler (insbesondere Coma, Astigmatismus und Bildfeldwirkung) teilweise kompensieren lassen, was ansonsten eine höhere Anzahl optischer Elemente (Linsen) innerhalb jedes Einzelkanals erfordern würde. Ein weiterer Vorteil ist, dass Licht 410, welches aus großem Einfallswinkel durch das Objektiv abgebildet werden soll, vor dem Erreichen der eigentlichen Linsenfläche durch die Filterschicht 200 in die Substratschicht 20 hinein gebrochen wird. Aufgrund des gegenüber der Umwelt höheren Brechungsindex der Substratschicht 20 passieren die Strahlen das Linsenprofil unter kleineren Winkeln, was zu einer Verringerung der optischen Abbildungsfehler (Aberrationen) führt.

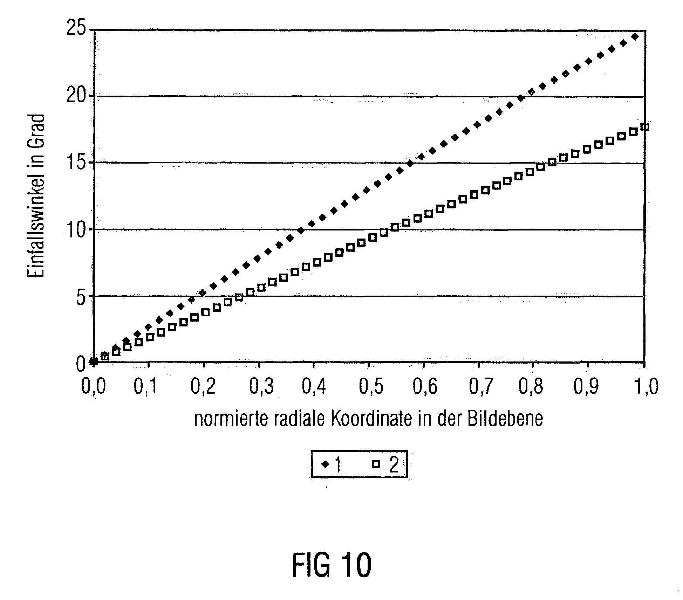

Weiterhin entstehen im zweiten Ausführungsbeispiel, je nach Blickwinkel im Objektfeld, nahezu ebenso große Einfallswinkel der Hauptstrahlen auf die Bildebene (vgl. Fig. 10). Dies führt vor allem bei einem großen Einfallswinkel zu Abschottungen durch die dreidimensionale Pixelstruktur des optoelektronischen Bildsensors 100 sowie Übersprechen zwischen den benachbarten Photodioden 30'. Diese Effekte reduzieren die relative Beleuchtungsstärke sowie den Kontrast im Bild. Im Gegensatz dazu, treffen im dritten Ausführungsbeispiel die Hauptstrahlen der mittleren Felder (Objektzellen des Objektfeldes welche von den Photodioden in der Mitte der jeweiligen Bilddektorenmatrize 30 erfasst werden) in jedem Kanal unter kleinem Winkel auf die photoaktiven Flächen des optoelektronischen Bildsensors 100 auf, was sich vorteilhaft auf die relative Beleuchtungsstärke im Bild auswirkt.

Fig. 10 zeigt den Einfallswinkel in Grad, des jeweiligen Hauptstrahls auf die Ebene des Bildsensors, aufgetragen über der normierten radialen Koordinate in der Ebene des Bildsensors für ein mehrkanaliges Abbildungs- und Bildaufnahmesystem mit vollem Gesichtsfeldwinkel von 75°. Die Datenreihe 1 wurde mit dem zweiten Ausführungsbeispiel, Datenreihe 2 wurde mit dem dritten Ausführungsbeispiel erhalten.

Weiterhin kann, da das Mikrolinsenfeld 10 kopfüber montiert ist, auf der Vorderseite ein optischer Filter 200 (z. B. IR-Sperrfilter für Anwendungen im visuellen Licht) und/oder eine feldartige Anordnung spektraler Transmissionsfilter (z. B. kanalweise Rot-, Grün-, Blau-Farbfilter) integriert werden, da die Vorderseite des Mikrolinsenfeldes 10 plan ausgelegt ist. Des Weiteren kann die plane Grenzfläche zur Entspiegelung (z. B. AR-Beschichtung) und zum Schutz des darauffolgenden zweiten Aperturblendenfelds 11' vor Umwelteinflüssen (z. B. kratzfeste Beschichtung) dienen. Alternativ kann die feldartige Anordnung spektraler Transmissionsfilter (z. B. kanalweise Rot-, Grün- und Blau-Farbfilter) direkt zwischen dem ersten Aperturblendenfeld 11 und dem Mikrolinsenfeld 10 strukturiert sein.

Die als Feld ausgeführten Abstandshalter 40 bestehen empfehlenswerterweise entweder aus lichtundurchlässigem Material (z. B. Kunststoff, tief geätztes Silizium) oder transparenten Materialien (z. B. Kunststoff, Glas oder anorganisch organischem Polymer (z. B. ORMOCER)). Die Zwischenräume beinhalten ein Material mit, im Vergleich zu den Mikrolinsen, geringerem Brechungsindex (z. B: Luft, evakuierte Luft, Stickstoff oder ähnliches), damit durch die Linsen eine Fokussierung erreicht wird. Bei der Verwendung eines transparenten Materials für den Abstandshalter 40 ist die zweite Blendenfeldschicht 12 auf der Vorderseite des Substrats 21 in einigen Fällen notwendig, um optisches Übersprechen zwischen den Kanälen zu verhindern. Das erste Blendenfeld 12' wird aus demselben Grund in einigen Fällen zusätzlich benötigt, weiterhin können zusätzliche Blendenfelder eingebracht werden um das Übersprechen zwischen den Kanälen zusätzlich zu minimieren. Wie auch im zweiten Ausführungsbeispiel sind alternativ vertikale schräge Wände aus lichtundurchlässigem Material (z. B. lichtabsorbierendes Material oder tief geätztes Silizium) anstatt der horizontalen Blendenfelder 12, 12' zur Unterdrückung von optischem Übersprechen geeignet, jedoch technologisch mit erhöhtem Aufwand verbunden. Im Falle der vertikalen Kanalseparationsstruktur können die Substratschichten 21, 22 entfallen, solange die axialen Kanalseparationsstrukturen ein stabiles Gerüst für die Montage des Mikrolinsenfeldes 10 und der Substratschicht 20 darstellen. Die Lichtbündel werden dann axial nach den Mikrolinsen 10 in dem jeweiligen Füllmedium (z. B. Luft, evakuierte Luft, Stickstoff oder ähnliches) fokussiert.

Die durch den kopfstehenden Aufbau und die Abstandshalter 40 verursachten Kavitäten bedingen eine im Vergleich zum 2. Ausführungsbeispiel abgewandelte Aufbau- und Verbindungstechnik. Der Stapel aus Filterschicht 200, Substratschicht 20, Aperturblendenfelder 11, 11' und Mikrolinsen 10 kann getrennt vom Stapel der Abstandshalter 40 der Substratschichten 21, 22 mit ihren Blendenlagen 12, 12' hergestellt werden. Die beiden Komponenten können dann im Wafermaßstab mittels Marken präzise justiert und miteinander verbunden werden (z. B. Kleben, Löten oder anodisches Bonden). Das gesamte Mikrolinsenobjektiv kann dann wahlweise im Wafennaßstab oder in ausgesägten Einzelobjektiven auf dem optoelektronischen Bildsensor 100 justiert und gebondet werden. Alternativ können die Optikkomponenten schritt-oder schichtweise auf dem Optowafer mit der Vielzahl von Bildsensoren aufgebaut werden.

Um die Transmission des Nutzlichtes durch das Mikrolinsenobjektiv zu erhöhen, ist eine Entspiegelungsbeschichtung auf den gekrümmten Oberflächen der Mikrolinse 10 sowie auf der Frontfläche der Substratschicht 21 vorteilhaft.

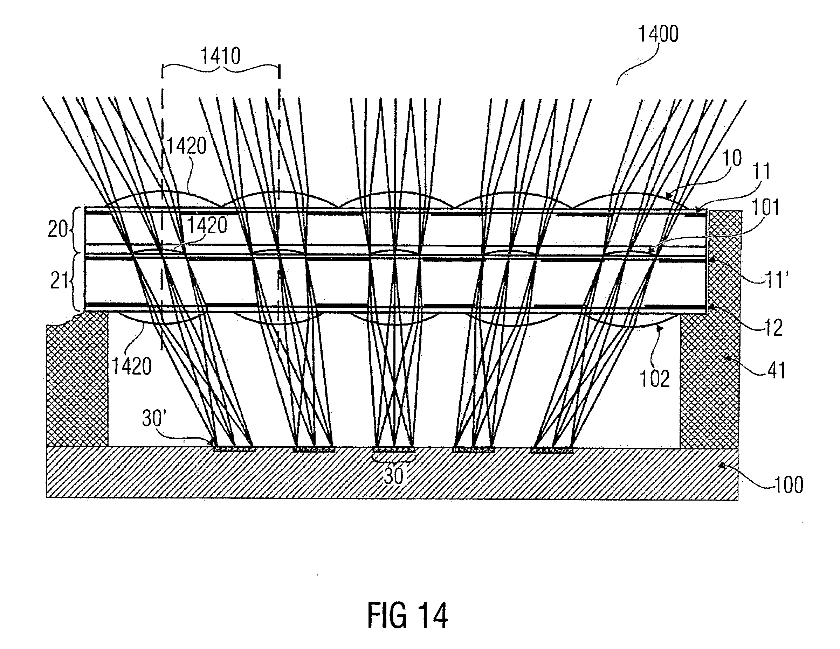

Fig. 14 zeigt ein Bild einer optischen Abbildungsvorrichtung 1400 gemäß einem vierten Ausführungsbeispiel der vorliegenden Erfindung. Im gezeigten Aufbau gemäß Fig. 14 werden drei Mikrolinsenfelder 10, 101, 102 hintereinander in einer annähernd symmetrischen Anordnung um das Aperturblendenfeld 11' verwendet. Es ist auch möglich, dass mehr als drei Mikrolinsenfelder verwendet werden. Das erste Mikrolinsenfeld 10, bestehend aus konvex-planen Linsen, befindet sich oberhalb (auf einer dem Objekt zugewandten Seite) einer dünnen Substratschicht 20, wobei zwischen der Substratschicht 20 und dem Mikrolinsenfeld 10 ein Aperturblendenfeld 11 strukturiert ist. Unterhalb der dünnen Substratschicht 20 befindet sich ein zweites Mikrolinsenfeld 101, dessen Linsen hier plan-konkav ausgelegt sind. Auf der Oberseite der folgenden Substratschicht 21, also zwischen der Substratschicht 21 und dem Mikrolinsenfeld 101, befindet sich ein Aperturblendenfeld 11', welches in jedem Kanal die eigentliche Systemaperturblende darstellt. Die Substratschicht 21 mit frontseitigem (dem Objekt zugewandten) Aperturblendenfeld 11' ist direkt mit der Restschicht des Mikrolinsenfeldes auf der Rückseite (dem Objekt abgewandt) der Substratschicht 20 verbunden, so dass ein monolithisches Abbildungsobjektiv entsteht. Auf der Substratrückseite der Substratschicht 21 befindet sich eine weitere horizontale Blendenlage 12, welche zur Unterdrückung von optischem Übersprechen dient. Ein weiteres plan-konvexes Mikrolinsenfeld 102 ist auf der Rückseite der Substratschicht 21 abgeformt. Der somit entstehende Schichtstapel wird mittels axialer Abstandshalterstrukturen 41 auf dem optoelektronischen Bildsensor 100 fixiert. Die Abstandshalter 41 sind am Rand des mehrkanaligen Objektivs ausgeführt. Die Abstandshalter 41 können aber auch kanalweise ausgeführt sein. Als Material für die Abstandshalter 41 kann insbesondere Glas, Kunststoff oder Metall verwendet werden. Das Material sollte lichtundurchlässig sein oder in nachfolgenden Schritten der Montage lichtundurchlässig gemacht werden (z. B. Schwärzen mit lichtabsorbierendem Material bei der Verwendung von Glas). Die jeweilige Photodiodengruppe 30 besitzt gegenüber den zugeordneten Mikrolinsen aus den Mikrolinsenfeldern 10, 101, 102 einen lateralen Versatz (Abstandsdifferenz - "Pitchdifferenz"), der die mittlere Beobachtungsrichtung (optischer Strahl welcher durch die Mikrolinse auf die Photodiode bzw. die Photodioden im Mittelpunkt der zugeordneten Photodiodenmatrize 30 trifft) des jeweiligen Kanals im Objektfeld vorgibt.

Ausgehend von der strukturellen Beschreibung werden nun die Funktionsweise und die Vorteile des der optischen Abbildungsvorrichtung 1400 gemäß dem vierten Ausführungsbeispiel erläutert. Die verschiedenen Mikrolinsenfelder 10, 101, 102 können aus verschiedenen Materialien (verschiedene Gläser, Kunststoffe, anorganische organische Polymere etc.) abgeformt sein, um z. B. chromatische Abbildungsfehler durch die unterschiedlichen ispersionseigenschaften der Materialien zu korrigieren. Des Weiteren kann eines oder mehrere der ikrolinsenfelder 10, 101, 102 als Feld achromatischer Elemente ausgelegt sein. Durch den am Objektivrand angebrachten lichtundurchlässigen axialen Abstandshalter 41 sind sowohl das mehrkanalige Abbildungssystem als auch die photoempfindlichen Bereiche des optoelektronischen Bildsensors 100 vor seitlich einfallendem Streulicht geschützt. Weiterhin können alternativ auch die Mikrolinsenfelder 10, 101, 102 einen zueinander unterschiedlichen Mittenabstand aufweisen, so dass die Verbindungslinien 1410 zwischen den Scheitelpunkten 1420 der einzelnen Mikrolinsen aus 10, 101, 102, zwischen benachbarten Kanälen einen Winkel einschließen und nicht wie bei der optischen Abbildungsvorrichtung 1400 gemäß Fig. 14 gezeigt, parallel sind.

Durch den beschriebenen Aufbau entsteht in jedem Kanal ein kleines Mikroobjektiv, welches ein Bild des jeweilig zugeordneten Objektabschnittes bzw. Objektausschnitts auf die ihm zugeordnete Gruppe von Photodioden 30 des optoelektronischen Bildsensors 100 abbildet. Dabei wird explizit keine zweistufige Abbildung mit Zwischenbildern benutzt, eine kleinstmögliche Baulänge des Gesamtobjektives zu erhalten. Die Anordnung der drei Mikrolinsenfelder 10, 101, 102 gemäß Fig. 14 ist vorteilhaft, um innerhalb jedes einzelnen Kanals die optischen Abbildungsfehler (wie Verzeichnung, chromatische Fehler und Coma) zu reduzieren und somit das optische Auflösungsvermögen gegenüber den deren Ausführungsbeispielen zu erhöhen. Vor allem ist mit diesem vierten Ausführungsbeispiel die tonnenförmige Verzeichnung zu größten Teilen korrigiert, so dass sich das Auflösungsvermögen des Gesamtbildes für große Objektfeldwinkel nicht mehr in Folge der Verzeichnungen reduziert. Durch die erhöhte Komplexität wird außerdem die Erhöhung der optischen Lichtstärke (Verringerung der Blendenzahl) ermöglicht.

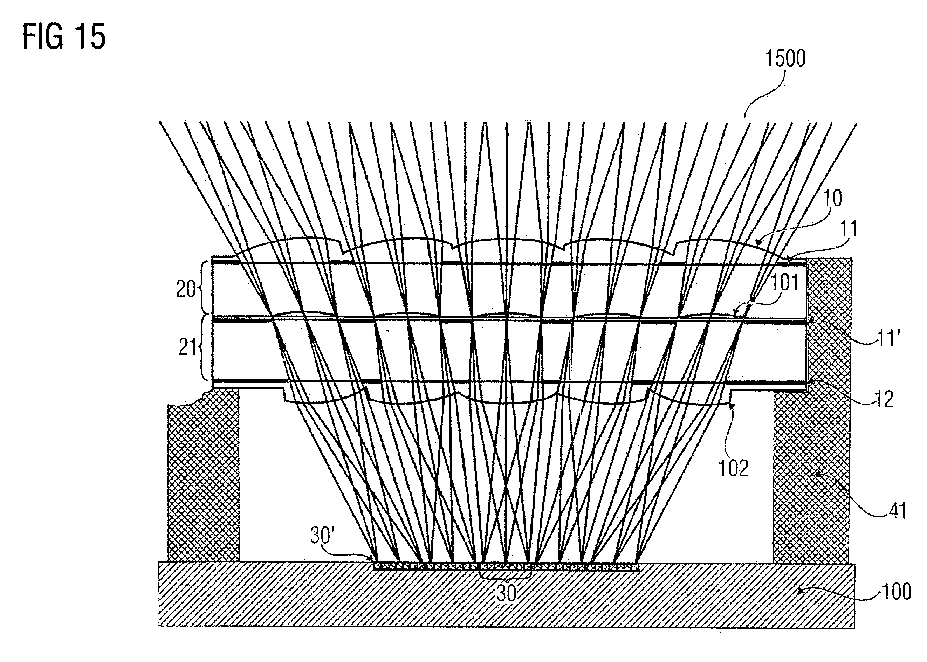

In Fig. 15 ist eine optische Abbildungsvorrichtung 1500 gemäß einem fünften Ausfühngsbeispiel der vorliegenden Erfindung gezeigt. Die optische Abbildungsvorrichtung 1500 umfasst im Gegensatz zu dem vierten Ausführungsbeispiel an der Oberseite einer Substratschicht 20 ein Mikrolinsenfeld, welches als ein Feld refraktiver Freiformflächen 10 ausgebildet ist, sowie an der Unterseite einer Substratschicht 21 ein Mikrolinsenfeld, welches als ein zweites Feld refraktiver Freiformflächen 102 ausgebildet ist. Unter einem Feld refraktiver Freiformflächen wird hier allgemein ein Mikrolinsenfeld verstanden, bei dem sich einzelne Linsenparameter (also auch die Form und Größe der Apertur) von Kanal zu Kanal (bzw. von Freiformfläche zu Freiformfläche) unterscheiden. Das erste Feld refraktiver Freiformflächen 10 und ein dazugehöriges Aperturblendenfeld 11 befinden sich oberhalb der dünnen transparenten Substratschicht 20. Auf der Rückseite der Substratschicht 20 befindet sich ein plan-konkaves Mikrolinsenfeld 101. Auf der Frontseite der axial folgenden Substratschicht 21 befindet sich ein Aperturblendenfeld 11'. Die Substratschicht 21 mit frontseitigem Aperturblendenfeld 11' ist direkt mit der Restschicht des Mikrolinsenfeldes 10 auf der Rückseite der Substratschicht 20 verbunden, so dass ein monolithisches Abbildungsobjektiv entsteht. Auf der Substratrückseite der Substratschicht 21 befinden sich eine horizontale Blendenlage 12, welche zur Unterdrückung von optischem Übersprechen dient, und das zweite Feld refraktiver Freiformflächen 102. Die verschiedenen Mikrolinsenfelder (bzw. refraktiven Freiformflächenfelder) 10, 101, 102 können aus verschiedenen Materialien (verschiedene Gläser, Kunststoffe, anorganische-organische CoPolymere etc.) bestehen, um z. B. chromatische Abbildungsfehler durch die unterschiedlichen Dispersionseigenschaften der Materialien zu korrigieren. Des Weiteren kann eines oder mehrere der Mikrolinsenfelder (bzw. refraktiven Freiformflächenfelder) 10, 101, 102 als Feld achromatischer Elemente ausgelegt sein. Das mehrkanalige Abbildungsobjektiv wird mittels axialer Abstandshalterstrukturen 41 auf dem optoelektronischen Bildsensor 100 fixiert. Diese Abstandshalter 41 sind am Rand des mehrkanaligen Objektivs ausgeführt, können wahlweise aber auch kanalweise ausgeführt sein. Als Material kann insbesondere Glas, Kunststoff oder Metall verwendet werden. Das Material sollte lichtundurchlässig sein oder in nachfolgenden Schritten der Montage lichtundurchlässig gemacht werden (z. B. Schwärzen mit lichtabsorbierendem Polymer bei der Verwendung von Glas).

Unter einem Brennpunkt wird hier für asphärische Linsen und refraktive Freiformflächen allgemein der Punkt verstanden, an dem normal (beispielsweise normal zu einer Hauptoberfläche des Bildsensors 100) einfallendes Licht gebündelt wird.

Durch den am Objektivrand angebrachten lichtundurchlässigen axialen Abstandshalter 41 sind sowohl das mehrkanalige Abbildungssystem als auch die photoempfindlichen Bereiche des optoelektronischen Bildsensors 100 vor seitlich einfallendem Streulicht geschützt. Die jeweilige Photodiodengruppe 30 besitzt gegenüber den zugeordneten Mikrolinsen bzw. refraktiven Freiformflächen aus den Mikrolinsenfeldern bzw. refraktiven Freiformflächenfeldern 10, 101, 102 einen lateralen Versatz (Abstandsdifferenz - "Pitchdiserenz"), der die mittlere Beobachtungsrichtung des jeweiligen Kanals im Objektfeld vorgibt.

Ausgehend von der Struktur werden nun die Funktionsweise und die Vorteile des fünften Ausführungsbeispiels beschrieben. Die in Fig. 15 gezeigte optische Abbildungsvorrichtung 1500 gemäß dem fünften Ausführungsbeispiel besitzt gegenüber der in Fig. 14 gezeigten optischen Abbildungsvorrichtung 1500 gemäß dem vierten Ausführungsbeispiel einen höheren optischen Füllfaktor. Dies wird durch die Verwendung von mindestens einer feldartigen Anordnung von refraktiven Formflächen (bei der optischen Abbildungsvorrichtung 1500 gemäß Fig. 15 werden beispielsweise zwei Felder refraktiver Freiformflächen verwendet - das erste Feld refraktiver Freiformflächen 10 und das zweite Feld refraktiver Freiformflächen 102) als Ersatz für ein jeweiliges Mikrolinsenfeld erreicht. Die laterale Ausdehnung dieser Freiformflächen innerhalb jedes Kanals ist nicht wesentlich größer ist als der zur jeweiligen Photodiodengruppe gehörende ausgeleuchtete Bereich einer im Vergleich zu einer Freiformfläche größeren (vollständigen) Mikrolinse. Aus diesem Grund können die Gruppen der Photodioden (Photodiodenmatrizen 30), dicht gepackt nebeneinander angeordnet sein, was eine kleinere aktive Fläche, im Vergleich zur Nutzung von Mikrolinse, des optoelektronischen Bildsensors 100 und somit eine Reduktion der Herstellungskosten des optoelektronischen Bildsensors 100 bedeutet.

Wie auch schon bei der optischen Abbildungsvorrichtung 1400 gemäß dem vierten Ausführungsbeispiel, wird auch bei der optischen Abbildungsvorrichtung 1500 gemäß dem vierten Ausführungsbeispiel, eine axial annähernd symmetrische Anordnung, um das Aperturblendenfeld 11' mit den, bei dem vierten Ausführungsbeispiel benannten, Vorteilen zur Erhöhung des optischen Auflösungsvermögen verwendet. Verzeichnung kann in der gezeigten Anordnung vorrangig durch den axial symmetrischen optischen Aufbau innerhalb jedes Kanals stark reduziert werden. In Folge der Optimierungen der kanalweisen Korrektur von Abbildungsfehlern unter schrägem Lichteinfall ist die unabhängige Anpassung der tangentialen und sagittalen Mikrolinsenparameter bevorzugt. Die Abbildung durch jeweils eine (somit anamorphotische) refraktive Freiformfläche pro Kanal erzeugt allerdings verschiedene Abbildungsmaßstäbe in tangentialer und sagittaler Richtung, was eine einachsige Verzerrung jedes Mikrobildes zur Folge hat. Diese Verzerrung kann vorteilhaft durch die kanalweise Ortstransformation und Interpolation der Pixelwerte (beispielsweise unter Verwendung einer zweiten Verarbeitungseinrichtung 52 gemäß Fig. 4) korrigiert werden, um einen Anschluss (passende Verbindung) der Bilddetails benachbarter optischer Kanäle und somit ein hohes Auflösungsvermögen im Gesamtbild zu gewährleisten. Alternativ kann, wie in Fig. 15 gezeigt, eine zweite refraktive Freiformfläche pro Kanal eingesetzt werden, um gleichzeitig mit der kanalweisen Korrektur von Abbildungsfeldem unter schrägem Lichteinfall auch die Variation des Abbildungsmaßstabes in tangentialer und sagittaler Richtung optisch zu korrigieren.

Die refraktiven Freiformflächen 10, 102 können kanalweise zumindest annähernd durch Segmente größerer bikonischer Mikrolinse (d. h. Mikrolinsen, die zwei asphärische Profile mit unterschiedlicher Konik entlang zweier senkrechter Schnitte durch das Oberflächenprofil aufweisen) beschrieben werden. Das Oberflächenprofil einer bikonischen Linse ist somit im Allgemeinen nicht rotationssymmetrisch, also anamorphotisch. Die exakte mathematische Beschreibung ihrer kanalweise verschiedenen Oberflächenprofile erfolgt durch eine Polynomentwicklung der axialen Pfeilhöhe in Abhängigkeit von den zweidimensionalen Koordinaten in Bezug auf einen Referenzpunkt. Aufgrund der unstetigen Strukturüberhänge zwischen den benachbarten Kanälen werden für diese feldartig angeordneten refraktiven Freiformflächen Herstellungsverfahren wie Laserschreiber, Grauton oder Zweiphotonenlithographie sowie alternativ Heiß- oder Glasprägen, notwendig. Alternativ kann eine Ultrapräzisionsbearbeitung zur Herstellung eines Masters für entsprechende Abformwerkzeuge dienen.

Weiterhin sind Ausführungsbeispiele verwendbar, welche von den bisher gezeigten Ausführungsbeispielen abweichen. So können sich in einem weiteren Ausführungsbeispiel z. B. die Mikrolinsen innerhalb der Feldanordnung in mindestens einem ihrer Strukturparameter (beispielsweise Form der Grundfläche, Durchmesser, Pfeilhöhe, Krümmungsradius, Mittelpunktabstand und andere) voneinander unterscheiden. Weiterhin ist es möglich, dass, insbesondere die Oberflächenprofile der Mikrolinsen sphärisch, torisc (d. h. zwei sphärische Krümmungsradien entlang zweier senkrechter Schnitte), bikonisch (d. h. zwei asphärische Profile mit unterschiedlicher Konik entlang zweier senkrechter Schnitte) oder asphärisch sein können. Weiterhin können die Mikrolinsen ebenfalls als refraktive optische Freiformflächen ausgebildet sein. Die Mikrolinsen sind im Allgemeinen refraktiv, können aber in einem anderen Ausführungsbeispiel auch diffraktiv oder eine Mischform aus beiden sein. Weiterhin ist es möglich, dass die einzelnen Mikrolinsen der Mikrolinsenfelder als Achromaten ausgebildet sind, um Farblängs- sowie Farbquerfehler zu minimieren. Weiterhin ist es möglich, dass das Mikrolinsenfeld bzw. die Mikrolinsenfelder sowie evtl. weitere Grenzflächen zwischen Materialien mit unterschiedlichen Brechungsindices mit reflexionsmildernden Schichten (AR-Beschichtung) versehen sind.

Eine weitere Möglichkeit der Hardwareverzeichnungskorrektur stellt die Variation der physischen Mittenabstände der Photodioden 30' im optoelektronischen Bildsensor 100 dar. Die kanalspezifische Verzeichnung kann somit durch einen für die Optik angepassten Bildsensor 100 mit einer kanalabhängigen Veränderung der Anordnung der Photodioden 30' innerhalb des Mikrobildbereiches korrigiert werden. Die kanalspezifische Anordnung der Photodioden 30' kann dafür aus den Optikdesigndaten und insbesondere dem kanalweisen Verzeichnisverlauf ermittelt werden (vgl. Fig. 8).

Weiterhin ist es möglich, dass falls die Photodiodengruppen 30 auf dem optoelektronischen Bildsensor 100 in einer hexagonalen, quadratischen, rechteckigen oder deren Verteilung angeordnet sind, dass auch die zugeordneten Mikrolinsen 10 in einer hexagonalen, quadratischen, rechteckigen oder anderen Verteilung angeordnet sind.

Zusammenfassend lässt sich sagen, dass es sich bei Ausführungsbeispielen gemäß der vorliegenden Erfindung um ein mehrkanaliges Abbildungs- und Bildaufnahmesystem handelt, Ein Abbildungs- und Bildaufhahmesystem gemäß der vorliegenden Erfindung besteht aus einem oder mehreren Mikrolinsenfeldern und einem ilddetektorenfeld, welches in jedem Kanal einen Teilbereich des Objektfeldes erfasst, abbildet und aus den elektronischen/digitalen Signale aller Einzelkanäle ein Gesamtbild des ausgedehnten Objektfeldes zusammensetzt. Das System ist völlig eigenständig abbildend und muss nicht mit anderen Optiken kombiniert werden. Dies stellt einen Gegensatz zu Mikrolinsenfeldern auf den jeweiligen Photodioden von Bildsensoren, welche nicht abbildend, sondern nur lichtbündelnd zur Erhöhung des optischen Füllfaktors dienen, dar. Gegenüber dem bekannten Stand der Technik, entstehen damit unter anderem die folgenden Vorteile. Die Aufbau- und Verbindungstechnik kann zum größten Teil (Optikkomponenten zu Abstandshalterschichten, mehrkanaliges Objektiv zum optoelektronischen Bildsensor) für zahlreiche Systeme parallel im Wafermaßstab erfolgen. Die Genauigkeit dieser Verfahren liegt aufgrund der Verwendung von optischer Justageunterstützung mittel Justiermarken im µm-Bereich. Dadurch werden der Anteil manueller Montage und die Montagezeit pro Modul deutlich verringert, was zu Kostenvorteilen führt Ein weiterer Vorteil ist, dass die Verwendung von mehreren Pixeln pro Kanal und einem speziell angepassten Abtastprinzip gegenüber bereits bekannten künstlichen Appositionsfacettenaugen ein wesentlich höheres Bildauflösungsvermögen bei gleicher oder sogar geringerer Sensorgrundfläche erlaubt. Aus diesem Grund verringern sich die Herstellungskosten des optoelektronischen Bildsensors und damit die Herstellungskosten des Gesamtsystems. Ein weiterer Vorteil ist, dass die Verwendung von kanalweiser Signalvorverarbeitung, insbesondere zur Korrektur von optischer Verzeichnung innerhalb jedes Mikrobildes, die Segmentierung des Objektfeldes ohne Verringerung des Auflösungsvermögens im Gesamtfeld ermöglicht, wobei ein Mikrobild bei der Abbildung eines Teilbereiches des Objektfeldes, durch eine Mikrolinse auf eine Bilddetektorenmatrize entsteht. Weiterhin wird aufgrund der Aufteilung der Abbildung des Objektfeldes durch eine Vielzahl von getrennten optischen Kanälen eine Verkürzung der Baulänge des optischen Systems ermöglicht und trotzdem die Erfassung eines großen Objektfeldbereichs ermöglicht (insbesondere skaliert die Größe des erfassbaren Objektfeldes mit der Anzahl der Kanäle und der lateralen Systemgröße, ist aber unabhängig von der Baulänge). Weiterhin wird ein großes Objektfeld mit nahezu konstantem Auflösungsvermögen über das gesamte Feld abgebildet, obwohl pro Kanal ein einfaches (einfach herzustellendes) optisches System verwendet wird. Weiterhin ist eine kostengünstige Produktion und Montage des Abbildungsobjektives aber auch eine kosteneffiziente Aufbau- und Verbindungstechnik zum optoelektronischen Bildsensor durch zur Halbleiterstrukturierungstechnik verwandte Herstellungsprozesse im Wafermaßstab, möglich. Ein weiterer Vorteil ist die Erhöhung des Bildauflösungsvermögens (bis etwa 1000 x 1000 Pixel oder sogar noch mehr) durch Verwendung von mehreren Pixeln pro Kanal in Verbindung mit den optischen Anordnungen zur kanalweisen Korrektur von Abbildungsfehlern (insbesondere Coma, Astigmatismus, Bildfeldwölbung). Durch zusätzliche Verwendung von kanalweiser Bildvorverarbeitung zur Korrektur von Verzeichnung wird ein fehlerfreier Anschluss der Mikrobilddetails ermöglicht. Weiterhin ermöglicht eine optische Abbildungsvorrichtung gemäß der vorliegenden Erfindung eine Erhöhung des Quotienten aus Bildauflösungsvermögen und benötigter Fläche des optoelektronischen Bildsensors und somit eine Verringerung der Gesamtsystemkosten. Außerdem kann durch eine geeignete Variation des optischen Aufbaus (siehe drittes Ausführungsbeispiel) der zum Rand anwachsende Abfall der Bildhelligkeit verringert werden. Zusätzlich bietet sich die Möglichkeit der einfachen Integration von spektralen Transmissionsfiltern (z. B. IR-Sperrfilter und/oder Farbfilter).

Beispielhafte Parameterbereiche für alle Ausführungsbeispiele werden im Folgenden aufgezeigt Der typische Durchmesser der Mikrolinsen kann im Bereich von 10 µm bis 1 mm liegen, wobei die Brennweite der Mikrolinse typischerweise im Bereich von 30 µm bis 3 mm liegen kann. Im zweidimensionalen Feld kann die Anzahl der Mikrolinsen bzw. Kanäle typischerweise 4 bis 250000 betragen, während sie im eindimensionalen Feld typischerweise 2 bis 1000 betragen kann. Aufgrund der Vorteile, die eine optische Abbildungsvorrichtung gemäß der vorliegenden Erfindung besitzt, resultiert eine komplette Baulänge der Abbildungsoptik typischerweise in den Größen von 50 µm bis 4,5 mm. Die Gesamtbildauflösung einer optischen Abbildungsvorrichtung gemäß der vorliegenden Erfindung liegt typischerweise zwischen 10000 Pixeln bis 10 Megapixel oder mehr.

Ein abbildendes Mikrolinsenfeld (beispielsweise auf einem dünnem Substrat mit Blendenlagen) auf einem Bildsensor gemäß einem Ausführungsbeispiel der vorliegenden Erfindung lässt sich eindeutig von herkömmlicher Einkanaloptik unterscheiden (Aufbau ist dann typischerweise hybrid, da Linse getrennt hergestellt (Spritzguß) und mit dem Bildsensor in ein gemeinsames Gehäuse eingebaut wird),

Aufgrund ihrer möglichen ultrakompakten Bauweise und der potentiell kostengünstigen Herstellungstechnologie sind mehrkanalige Abbildungs- und Bilderfassungserfassungssysteme, gemäß der vorliegenden Erfindung, zum Einsatz in Produkten der Unterhaltungselektronik (Laptop, Spielekonsolen, Spielzeug) und vor allem für den Einsatz in portablen Geräten (Mobiltelefon, PDA und andere) prädestiniert. Weitere Anwendungsgebiete gibt es in der Sensorik (z. B. kameraartige Sensoren, bildgebende Sensoren in der Produktionstechnik), in der Automobiltechnik (z. B. optische Sicherheitssensoren im Automobilinnenraum, Fahrassistenzsysteme, wie Rückfahrkamera, Fahrspurerkennung etc.), in der Sicherheitenüberwachung (z. B. umschaltbare Umweltkameras mit großem Gesichtsfeld an/in Gebäuden, Museen, Objekten), in der Robotik (z. B. als optischer Sensor zur Navigation, optische Steuerung von Greifern oder Bauteilaufnahmevorrichtungen), und in der Medizintechnik (z. B. Einsatz in bildgebenden Diagnoseverfahren, Endoskopie).

Ausführungsbeispiele der Verfahren können um alle Aspekte und Funktionalitäten der erfindunsgemäßen Vorrichtungen ergänzt werden.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines deren magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein. Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft. Der Programmcode kann beispielsweise auch auf einem aschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft. Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

Ein Ausführungsbeispiel der Erfindung schafft eine Vorrichtung zur optischen Abbildung mit mindestens einem Mikrolinsenfeld mit mindestens zwei Mikrolinsen, einem Bildsensor mit mindestens zwei Bilddetektorenmatrizen, wobei die zumindest zwei Bilddetektorenmatrizen jeweils eine Mehrzahl von Bilddetektoren umfassen, wobei eine Zuordnung zwischen den Bilddetektorenmatrizen und den Mikrolinsen besteht, so dass jede Mikrolinse zusammen mit einer Bilddetektorenmatrize einen optischen Kanal bildet, wobei Mittelpunkte verschiedener Bilddetektorenmatrizen lateral unterschiedlich weit gegenüber, auf die Bilddetektorenmatrizen projizierten Flächenschwerpunkten der Mikrolinsenaperturen der zugehörigen optischen Kanäle verschoben sind, so dass zumindest zwei der optischen Kanäle unterschiedliche, teilweise überlappende Erfassungsbereiche aufweisen, und so dass ein Überlappbereich der Erfassungsbereiche zweier Kanäle im Hinblick auf ein Bilddetektorraster der Bilddetektorenmatrizen versetzt auf die Bilddetektorenmatrizen abgebildet wird.

Bei einem bevorzugten Auführungsbeispiel ist die Vorrichtung ausgebildet, so dass der Überlappbereich eine Mehrzahl von Objektzellen aufweist, wobei jede der Objektzellen auf zumindest einen Bilddetektor des Bildsensors abbildbar ist, und bei der jedem optischen Kanal ein Abtastgitter zugeordnet ist, wobei ein Abtastgitter des ersten optischen Kanals beschreibt, welche Objektzellen des Überlappbereichs auf welche Bilddetektoren der Bilddetektorenmatrize des ersten optischen Kanals abgebildet werden und, wobei ein Abtastgitter des zweiten optischen Kanals beschreibt, welche Objektzellen des Überlappbereichs auf welche Bilddetektoren der Bilddetektorenmatrize des zweiten optischen Kanals abgebildet werden, und wobei das Abtastgitter des ersten optischen Kanals so gewählt ist, dass eine erste Objektzelle auf einen ersten Bilddetektor der Bilddetektorenmatrize des ersten optischen Kanals abgebildet wird, und dass eine zweite, der ersten Objektzelle benachbarte, Objektzelle auf einen Zwischenraum zwischen dem ersten Bilddetektor der Bilddetektorenmatrize des ersten optischen Kanals und einem zweiten, dem ersten Bilddetektor benachbarten, Bilddetektor der Bilddetektorenmatrize des ersten optischen Kanals abgebildet wird, und wobei das Abtastgitter des zweiten optischen Kanals so gewählt ist, dass die zweite Objektzelle auf einen ersten Bilddetektor der Bilddetektorenmatrize des zweiten optischen Kanals abgebildet wird, und dass die erste Objektzelle auf einen Zwischenraum zwischen dem ersten Bilddetektor der Bilddetektorenmatrize des zweiten optischen Kanals und einen zweiten, dem ersten Bilddetektor benachbarten, Bilddetektor der Bilddetektorenmatrize des zweiten optischen Kanals abgebildet wird.

Bei einem bevorzugten Auführungsbeispiel ist die Vorrichtung ausgebildet, so dass das Abtastgitter des ersten optischen Kanals um ein nicht-ganzzahliges Vielfaches eines Abtastintervalls gegenüber dem Abtastgitter des zweiten optischen Kanals verschoben ist, so dass eine dritte, der zweiten Objektzelle benachbarte, Objektzelle auf dem zweiten Bilddetektor der Bilddetektorenmatrize des ersten optischen Kanals abgebildet wird, und wobei das Abtastintervall gleich dem Abstand des Mittelpunktes der ersten Objektzelle zu dem Mittelpunkt der dritten Objektzelle ist.

Bei einem bevorzugten Auführungsbeispiel ist die Vorrichtung ausgebildet, um in jedem optischen Kanal ein Mikrobild des jeweiligen Erfassungsbereiches zu erzeugen, wobei ein Mikrobild eine Mehrzahl von Pixeln umfasst, wobei ein Pixel durch eine Abbildung einer Objektzelle auf einem Bilddetektor entsteht, und wobei ein Mikrobild des ersten optischen Kanals mit einem Mikrobild des zweiten optischen Kanals so verschränkt ist, dass entlang einer Linie benachbarte Objektzellen des Überlappbereichs des ersten und des zweiten Kanals abwechselnd zu verschiedenen Mikrobildern zugeordnet werden.

Bei einem bevorzugten Auführungsbeispiel ist die Vorrichtung ausgebildet, so dass der Bildsensor in einer Brennebene der Mikrolinse des Mikrolinsenfeldes geordnet ist, wobei sich zwischen dem Bildsensor und dem Mikrolinsenfeld eine Abstandshalterschicht befindet, wobei die Abstandshalterschicht eine Mehrzahl von Kanalseparationsstrukturen umfasst, die ausgebildet sind, um ein optisches Übersprechen zwischen benachbarten optischen Kanälen zu unterdrücken, und wobei die Abstandshalterschicht mindestens ein Aperturblendenfeld umfasst, das ausgebildet ist, um Streulicht durch die Zwischenräume zwischen den Mikrolinse zu unterdrücken,

Bei einem bevorzugten Auführungsbeispiel ist die Vorrichtung ausgebildet, so dass eine Mehrzahl der optischen Kanäle unterschiedliche spektrale Transmissionsfelder umfassen, so dass in den optischen Kanälen jeweils ein zugehöriges Mikrobild entsteht, wobei Mikrobilder unterschiedlicher Kanäle unterschiedlichen Spektralfarben zugeordnet sind, wobei die optischen Kanäle durch Kanalseparationsstrukturen getrennt sind, um Farbübersprechen zu unterbinden; wobei benachbarte Kanäle verschiedene spektrale Transmissionsfelder umfassen, und die Mikrobilder der benachbarten Kanäle so verschränkt sind, dass entlang einer Linie benachbarte Objektzellen des Überlappbereichs der optischen Kanäle abwechselnd den verschiedenen spektralen Mikrobildern zugeordnet werden.

Bei einem bevorzugten Auführungsbeispiel ist die Vorrichtung ausgebildet, so dass sie einen Sensor zur Messung des Abstandes zwischen der Vorrichtung und einem zu erfassenden Objekt umfasst, wobei die Vorrichtung ausgelegt ist, um einen Versatz von einer Abbildung einer ersten Objektzelle auf einen ersten Bilddetektor einer Bilddetektorenmatrize eines ersten optischen Kanals, zu einer Abbildung einer zweiten, der ersten Objektzelle benachbarten, Objektzelle auf einen ersten Bilddetektor einer Bilddetektoremnatrize eines zweiten optischen Kanals zu korrigieren, und bei der Korrektur den lateralen Abstand der Bilddetektoremnatrize des ersten optischen Kanals zu der Bilddetektorenmatrize des zweiten optischen Kanals zu berücksichtigen.

Bei einem bevorzugten Aufiwnmgsbeispiel ist die Vorrichtung ausgebildet, so dass verschiedene Mikrolinsen sich in mindestens einem ihrer Strukturparameter unterscheiden, wobei die Mikrolinsen, so geformt sind, dass alle in dieselbe Brennebene abbilden.

Bei einem bevorzugten Aufuhrungsbeispiel ist die Vorrichtung ausgebildet, so dass mindestens eine Mikrolinse als Achromat ausgebildet ist.

Bei einem bevorzugten Aufuhrungsbeispiel ist die Vorrichtung ausgebildet, so dass das Mikrolinsenfeld und/oder eine Grenzfläche zwischen einem transparenten Material und Luft eine reflektionsmindernde Schicht aufweist.

Bei einem bevorzugten Auführungsbeispiel ist die Vorrichtung ausgebildet, so dass das Mikrolinsenfeld sowie die Bilddetektorenmatrizen in einer hexagonalen oder einer quadratischen oder einer rechteckigen Verteilung angeordnet sind.

Bei einem bevorzugten Auführungsbeispiel ist die Vorrichtung ausgebildet, so dass das Mikrolinsenfeld als ein Feld von refraktiven Freiformflächen ausgebildet ist.

Bei einem bevorzugten Aufuhrungsbeispiel ist die Vorrichtung so ausgebildet ist, dass in jedem optischen Kanal ein Mikrobild mit einer Mehrzahl von Pixeln entsteht, wobei die Vorrichtung eine Bildverarbeitungseinrichtung zur Korrektur der Verzeichnung der Mikrobilder, sowie zur Rekonstruktion eines Gesamtbildes aus den Mikrobildern der optischen Kanäle umfasst, wobei die Bildverarbeitungseinrichtung ausgebildet ist, um die Korrektur der Verzeichnung jedes Mikrobild getrennt und zeitlich parallel durchzuführen, und wobei die Bildverarbeitungseinrichtung ausgebildet ist, um die Rekonstruktion des Gesamtbildes durch abwechselndes Anordnen der Pixel der verschränkten Mikrobilder durchzuführen, um so das Gesamtbild zu erhalten.

Bei einem bevorzugten Aufuhrungsbeispiel ist die Vorrichtung so ausgebildet, dass die Bildverarbeitungseinrichtung auf einem Chip mit dem Bildsensor ausgeführt ist, wobei die Bildverarbeitungseinrichtung eine Mehrzahl von Mikrobildverarbeitungseinrichtungen, zur Korrektur von Verzeichnungen, umfasst, die in den Zwischenräumen der Bilddetektorenmatrizen des Bildsensors angeordnet sind.

Ein weiteres Ausführungsbeispiel der Erfindung schafft ein Verfahren zur optischen Abbildung eines Objektes unter Verwendung eines Mikrolinsenfeldes mit mindestens zwei Mikrolinsen und eines Bildsensors, wobei der Bildsensor eine Mehrzahl von Bilddetektorenmatrizen umfasst und wobei jede Bilddetektormatrize eine Mehrzahl von Bilddetektoren umfasst und wobei jeder Mikrolinse eine Bilddetektorenmatrize zugeordnet ist, so dass jede Mikrolinse zusammen mit der zugeordneten Bilddetektorenmatrize einen optischen Kanal bildet, wobei das Verfahren das Abbilden des Objektes durch das Mikrolinsenfeld auf dem Bildsensor aufweist, derart, dass jede Objektzelle auf einen Bilddetektor abgebildet wird, wobei benachbarte Objektzellen auf Bilddetektoren von benachbarten optischen Kanälen abgebildet werden, so dass Mikrobilder auf den Bilddetektorenmatrizen der optischen Kanäle entstehen, wobei jedes Mikrobild mit den Mikrobildern der benachbarten Kanäle verschränkt ist.

Bei einem bevorzugten Auführungsbeispiel ist das Verfahren zur optischen Abbildung ausgebildet, so dass es ferner das Horizontale sowie vertikale Spiegelung der einzelnen Mikrobilder der optischen Kanäle, wobei die Spiegelung sämtlicher Mikrobilder zeitlich parallel erfolgt, die Umrechnung der Pixelwerte der Mikrobilder verschiedener optischer Kanäle aus ihrer diskreten Gitterstruktur, mittels einer Ortstransformation, auf eine kontinuierliche Koordinatenebene wobei eine Korrektur von Bildverzerrungen der Mikrobilder verschiedener optischer Kanäle erfolgt, das Abbilden der Pixelwerte von der kontinuierlichen Koordinatenebene auf ein neues diskretes Gitter um entzerrte Mikrobilder zu erhalten, wobei verschiedene optische Kanäle zeitlich parallel verarbeitet werden, und die Umsortierung der Pixelwerte der entzerrten Mikrobilder in eine Bildmatrix nach einem vorgegebenen Schema aufweist, welches durch die Verschränkung der Mikrobilder vorgegeben ist, um ein unverschränktes Gesamtbild zu erhalten.

Bei einem bevorzugten Auführungsbeispiel ist das Verfahren so ausgebildet, dass die Umrechnung der Pixelwerte der Mikrobilder verschiedener optischer Kanäle aus ihrer diskreten Gitterstruktur, mittels einer Ortstransformation, auf eine kontinuierliche Koordinatenebene zeitlich parallel erfolgt.

Ein weiteres Ausführungsbeispiel der Erfindung schafft ein Computerprogramm mit einem Programmcode zur Durchführung des oben genannten Verfahrens, wenn das Programm auf einem Computer abläuft.

## Patentansprüche

1. Bildverarbeitungsvorrichtung mit folgenden Merkmalen:
einem Bildsensor (100) mit einer Mehrzahl von Bilddetektoren (30', 32a, 32b),
wobei eine erste Mehrzahl von Bilddetektoren (32a) einer ersten Bilddetektorenmatrize (30a) zugeordnet sind;
wobei eine zweite Mehrzahl von Bilddetektoren (32b) einer zweiten Bilddetektorenmatrize (30b) zugeordnet sind;
einer Einheit zur Aufnahme eines Mikrolinsenfeldes, die ausgelegt ist, um ein Mikrolinsenfeld (10) derartig auf der Bildverarbeitungsvorrichtung zu befestigen, so dass der Bildsensor sich in der Brennebene des Mikrolinsenfeldes (10) befindet und eine Zuordnung zwischen den Bilddetektorenmatrizen (30; 30a, 30b) und Mikrolinsen (10a, 10b) des Mikrolinsenfeldes (10) besteht, so dass jede Mikrolinse (10a, 10b) zusammen mit einer Bilddetektorenmatrize (30; 30a, 30b), die eine Mehrzahl von Bilddetektoren (30', 32a, 32b) umfasst, einen optischen Kanal bildet;
wobei jedem optischen Kanal ein Abtastgitter (810,820) zugeordnet ist;
wobei die Einzelabbildungen benachbarter Kanäle miteinander verschränkt derart, dass Abtastgitter benachbarter Kanäle in nicht ganzzahligen Vielfachen des Abtastintervalls eines Einzelkanals gegeneinander verschoben sind; und
einer Bildverarbeitungseinrichtung (70) zur Korrektur von Bildfehlern und zur Rekonstruktion eines Gesamtbildes (300) aus den Abbildungen auf den Bilddetektoren (30', 32a, 32b) der Bilddetektorenmatrizen (30; 30a, 30b);
wobei die Bildverarbeitungseinrichtung (70) eine Mehrzahl von Verarbeitungseinrichtungen, zur Korrektur von Verzeichnungen, umfasst; und
wobei die Bildverarbeitungseinrichtung (70) ausgebildet ist, um die Korrektur der Bildfehler der Einzelabbildungen aller Bilddetektorenmatrizen (30; 30a, 30b), unabhängig voneinander zeitlich parallel auszuführen und um aus den Einzelabbildungen ein Gesamtbild zu rekonstruieren derart, dass die Verschränkung der Einzelabbildungen berücksichtigt ist.

2. Bildverarbeitungsvorrichtung gemäß Anspruch 1, bei der die Bildverarbeitungseinrichtung (70) auf einem Chip mit dem Bildsensor (100) ausgeführt ist.

3. Bildverarbeitungsvorrichtung gemäß Anspruch 2, bei der die Mehrzahl von Verarbeitungseinrichtungen zur Korrektur von Verzeichnungen in den Zwischenräumen der Bilddetektorenmatrizen des Bildsensors (100) angeordnet sind.

4. Bildverarbeitungsvorrichtung gemäß einem der Ansprüche 1 bis 3, wobei das Abtastgitter eines betrachteten Kanals die Gesamtheit derjenigen Objektpunkte in dem Schärfentiefenbereich des betrachteten Kanals ist, die auf die einzelnen Bilddetektoren (30', 32a, 32b) der Bilddetektorenmatrize (30; 30a, 30b) des betrachteten Kanals abgebildet werden.

## Claims

1. An image processing device, comprising:
an image sensor (100) having a plurality of image detectors (30', 32a, 32b),
wherein a first plurality of image detectors (32a) is associated with a first image detector matrix (30a);
wherein a second plurality of image detectors (32b) is associated with a second image detector matrix (30b);
a unit for receiving a micro lens field which is implemented to mount a micro lens field (10) on the image processing device such that the image sensor is located in the focal plane of the micro lens field (10) and an allocation between the image detector matrices (30; 30a, 30b) and micro lenses (10a, 10b) of the micro lens field (10) exists, so that each micro lens (10a, 10b) together with an image detector matrix (30; 30a, 30b), which includes a plurality of image detectors (30', 32a, 32b), forms an optical channel;
wherein a sampling grid (810, 820) is associated with each optical channel;
wherein the individual images of neighboring channels are interleaved such that sampling grids of neighboring channels are shifted in non-integer multiples of the sampling interval of the single channel with respect to each other; and
an image processing means (70) for correcting image errors and for the reconstruction of an overall image (300) from the images on the image detectors (30', 32a, 32b) of the image detector matrices (30; 30a, 30b);
wherein the image processing means (70) includes a plurality of processing means for correcting distortions; and
wherein the image processing means (70) is implemented to execute the correction of the image errors of the individual images of all image detector matrices (30; 30a, 30b) independently of each other parallel in time and to reconstruct an overall image from the individual images such that the interleaving of the individual images is considered.

2. The image processing device according to claim 1, wherein the image processing means (70) is implemented on a chip with the image sensor (100).

3. The image processing device according to claim 2, wherein the plurality of processing means for correcting distortions are arranged in the gaps of the image detector matrices of the image sensor (100).

4. The image processing device according to one of claims 1 to 3, wherein the sampling grid of a considered channel is the entirety of those object points in the depth of focus area of the considered channel, which are imaged onto the individual image detectors (30', 32a, 32b) of the image detector matrix (30; 30a, 30b) of the considered channel.

## Revendications

1. Dispositif de traitement d'image comprenant:
un capteur d'image (100) avec une pluralité de détecteurs d'image (30', 32a, 32b),
une première pluralité de détecteurs d'image (32a) étant associés à une première matrice de détecteurs d'image (30a);
une deuxième pluralité de détecteurs d'image (32b) étant associés à une deuxième matrice de détecteurs d'image (30b);
une unité destinée à recevoir un champ de microlentilles qui est conçu pour fixer un champ de microlentilles (10) au dispositif de traitement d'image de sorte que le capteur d'image se situe dans le plan focal du champ de microlentilles (10) et qu'il existe une association entre les matrices de détecteurs d'image (30; 30a, 30b) et les microlentilles (10a, 10b) de la matrice de microlentilles (10), de sorte que chaque microlentille (10a, 10b) constitue, ensemble avec une matrice de détecteurs d'image (30, 30a, 30b) comportant une pluralité de détecteurs d'image (30', 32a, 32b), un canal optique;
à chaque canal optique étant associé un réseau de balayage (810, 820);
les reproductions individuelles de canaux adjacents étant entrelacées entre elles de sorte que les réseaux de balayage de canaux adjacents soient décalés entre eux selon des multiples non entiers de l'intervalle de balayage d'un canal individuel; et
un moyen de traitement d'image (70) pour la correction d'erreurs d'image et la reconstruction d'une image complète (300) à partir des illustrations sur les détecteurs d'image (30', 32a, 32b) des matrices de détecteurs d'image (30; 30a, 30b);
dans lequel le moyen de traitement d'image (70) comporte une pluralité de moyens de traitement pour la correction de distorsions; et
dans lequel le moyen de traitement d'image (70) est conçu pour réaliser la correction des erreurs d'image des reproductions individuelles de toutes les matrices de détecteurs d'image (30; 30a, 30b) indépendamment les unes des autres en parallèle dans le temps et pour reconstruire à partir des reproductions individuelles une image complète de sorte qu'il soit tenu compte de l'entrelacement des reproductions individuelles.

2. Dispositif de traitement d'image selon la revendication 1, dans lequel le moyen de traitement d'image (70) est réalisé sur une puce avec le capteur d'image (100).

3. Dispositif de traitement d'image selon la revendication 2, dans lequel la pluralité de moyens de traitement pour la correction de distorsions sont disposés dans les espaces intermédiaires des matrices de détecteurs d'image du capteur d'image (100).

4. Dispositif de traitement d'image selon l'une des revendications 1 à 3, dans lequel le réseau de balayage d'un canal considéré est l'ensemble des points d'objet dans la profondeur de champ du canal considéré qui sont reproduits sur les détecteurs d'image individuels (30', 32a, 32b) de la matrice de détecteurs d'image (30; 30a, 30b) du canal considéré.
